# EUROPEAN PATENT SPECIFICATION

(11) **EP 3 872 580 B1**
(45) Date of publication and mention of the grant of the patent: **24.12.2025**
(21) Application number: 21158374.5
(22) Date of filing: 22.02.2021
(51) Int. Cl.: G04C 3/14, G04G 21/04

(54) **ELECTRONIC APPARATUS, DETERMINATION SYSTEM, DETERMINATION METHOD, AND PROGRAM**
ELEKTRONISCHE VORRICHTUNG, BESTIMMUNGSSYSTEM, BESTIMMUNGSVERFAHREN UND PROGRAMM
APPAREIL ÉLECTRONIQUE, SYSTÈME DE DÉTERMINATION, PROCÉDÉ DE DÉTERMINATION ET PROGRAMME

(30) Priority: 25.02.2020 JP 2020028992
(43) Date of publication of application: 01.09.2021
(73) Proprietor: Casio Computer Co., Ltd., Tokyo 151-8543 (JP)
(72) Inventor: HANADA, Takeshi, Tokyo 205-8555 (JP); KUROHA, Akihiro, Tokyo 205-8555 (JP); KUROTAKI, Asahi, Tokyo 205-8555 (JP); OIKAWA, Shuto, Tokyo 205-8555 (JP); SAWADA, Makoto, Tokyo 205-8555 (JP)
(74) Representative: Plougmann Vingtoft a/s

(56) References cited:
- US-A1- 2018 246 473

## Description

The present disclosure relates generally to an electronic apparatus, a determination system, a determination method, and a program.

A battery-operated timepiece such as a wristwatch ceases to function as a timepiece when the voltage is reduced due to the battery being depleted. Accordingly, battery-operated timepieces are often provided with a function of notifying the user of reductions in the voltage of the battery. For example, Unexamined Japanese Patent Application Publication No. 2015-135347 discloses an electronic timepiece that, when the voltage of the battery is reduced, changes the manner of advancing of the second hand so as to advance two seconds every two seconds and, when the voltage becomes further reduced, stop the second hand.

The electronic timepiece disclosed in Unexamined Japanese Patent Application Publication No. 2015-135347 can notify a user of a voltage reduction of the battery by changing the manner in which the second hand advances. However, the only thing the user can ascertain from this notification is the voltage reduction of the battery at that point in time. Even if a problem other than a voltage reduction of the battery has occurred in the electronic timepiece, the user cannot ascertain that problem. Moreover, in the related art, there are electronic timepieces that determine, at a specific timing, whether or not there is an abnormality, but this specific timing does not necessarily match the timing at which the user desires to determine whether or not there is an abnormality. Accordingly, in a case in which the timing at which the user desires to determine whether or not there is an abnormality and the specific timing do not match, the user must wait for the specific timing, even if the user desires to immediately determine whether or not there is an abnormality.

US 2018/246473 A1 discloses an electronic timepiece, including: a counter; a display section; a first processor; a second processor; and a power supply section which supplies electric power to each section from a battery, wherein when an output voltage from the power supply section decreases to less than a predetermined first reference voltage, the first processor stops a display operation by the display section, when the time information is acquired by the processing operation of the second processor, the first processor corrects the time counted by the counter based on the acquired time information and causes the display section to display the corrected time, and when the output voltage decreases to less than the first reference voltage following an acquisition operation of the time information by the second processor, the first processor does not stop a time display operation during a predetermined pending period.

The present disclosure is made with the view of the above situation, and an objective of the present disclosure is to provide an electronic apparatus, a determination system, a determination method, and a program, whereby it is possible to determine, at a desired timing of a user, whether or not there is an abnormality in a timepiece.

The inventions are as defined in claims 1, 11-13.

A more complete understanding of this application can be obtained when the following detailed description is considered in conjunction with the following drawings, in which:
FIG. 1 is a drawing illustrating a configuration example of a determination system according to Embodiment 1;
FIG. 2 is a block diagram illustrating the functional configuration of a smartphone according to Embodiment 1;
FIG. 3 is a drawing illustrating an example of log data stored in a log memory of the smartphone according to Embodiment 1;
FIG. 4 is a block diagram illustrating the functional configuration of an electronic timepiece according to Embodiment 1;
FIG. 5 is a flowchart of initialization processing according to Embodiment 1;
FIG. 6 is a flowchart of log data acquisition processing according to Embodiment 1;
FIG. 7 is a flowchart of information display processing according to Embodiment 1;
FIG. 8 is a first flowchart of battery status determination processing according to Embodiment 1;
FIG. 9 is a second flowchart of the battery status determination processing according to Embodiment 1;
FIG. 10 is a drawing illustrating an example of a display of a charging guidance according to Embodiment 1;
FIG. 11 is a drawing illustrating an example of a display of a notification center according to Embodiment 1;
FIG. 12 is a drawing illustrating an example of a display of a charging guidance requiring an improvement confirmation according to Embodiment 1;
FIG. 13 is a drawing illustrating an example of a display of a support center in the battery status determination processing according to Embodiment 1;
FIG. 14 is a flowchart of electricity generation status determination processing according to Embodiment 1;
FIG. 15 is a drawing illustrating another example of a display of a support center in the battery status determination processing according to Embodiment 1;
FIG. 16 is a first flowchart of magnetism status determination processing according to Embodiment 1;
FIG. 17 is a second flowchart of the magnetism status determination processing according to Embodiment 1;
FIG. 18 is a drawing illustrating an example of a display of a hand position correction guidance according to Embodiment 1;
FIG. 19 is a drawing illustrating an example of a display of a hand position correction guidance requiring an improvement confirmation according to Embodiment 1;
FIG. 20 is a drawing illustrating an example of a display of a support center in the magnetism status determination processing according to Embodiment 1;
FIG. 21 is a flowchart of time correction status determination processing according to Embodiment 1;
FIG. 22 is a drawing illustrating an example of a display of a time correction guidance according to Embodiment 1;
FIG. 23 is a drawing illustrating an example of displaying normal according to an alternative example of Embodiment 1;
FIG. 24 is a flowchart of information display processing according to the alternative example of Embodiment 1; and
FIG. 25 is a drawing illustrating an example of displaying abnormal according to the alternative example of Embodiment 1.

According to the present disclosure, a determination of whether or not there is an abnormality of a timepiece can be made at a desired timing of a user.

Hereinafter, embodiments of the present disclosure are described while referencing the drawings. Note that, in the drawings, identical or equivalent components are denoted by the same reference numerals.

### Embodiment 1

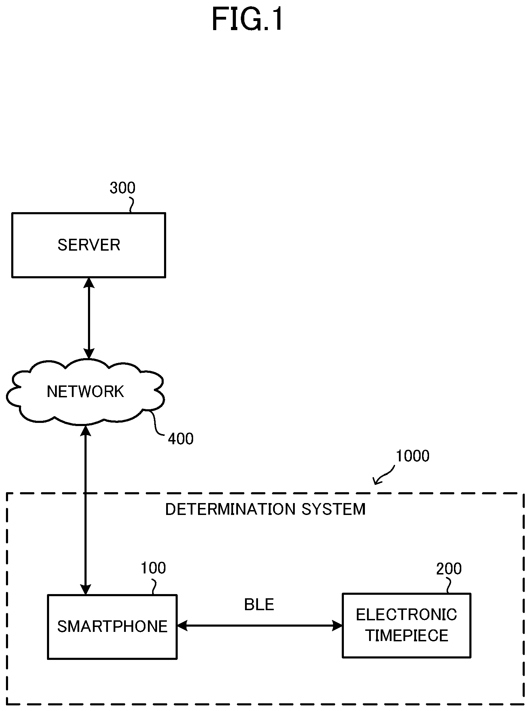

In the following, to facilitate comprehension, an example is described of a case in which a smartphone 100 according to Embodiment 1 of the present disclosure is applied to a determination system 1000 illustrated in FIG. 1. As illustrated in FIG. 1, the determination system 1000 includes the smartphone 100 and an electronic timepiece 200. Short-range wireless communication between the smartphone 100 and the electronic timepiece 200 is carried out via Bluetooth (registered trademark) low energy (hereinafter referred to as "BLE"). In Bluetooth (registered trademark), which is a short-range wireless communication standard, BLE is a standard (mode) established for the purpose of reducing power consumption and cost. The smartphone 100 is capable of communicating with a server 300 via a network 400. Any network can be used for the network 400. Examples thereof include the internet, long term evolution (LTE) (registered trademark), and the like.

The smartphone 100 acquires, from the electronic timepiece 200, log data expressing a variety of statuses and operation histories of the electronic timepiece 200, and performs a self-check of the electronic timepiece 200. Here, the term "self-check" means to inspect whether the electronic timepiece 200 is normal or abnormal by determining, from the log data, a battery status, an electricity generation status, a magnetism status, a time correction status, and the like of the electronic timepiece 200. The smartphone 100 displays, on the basis of these various statuses determined from the log data, information to be notified to a user. The smartphone 100 is capable of uploading the log data to the server 300 via the network 400. As such, the server 300 can collect log data from multiple electronic timepieces 200 via a plurality of smartphones 100.

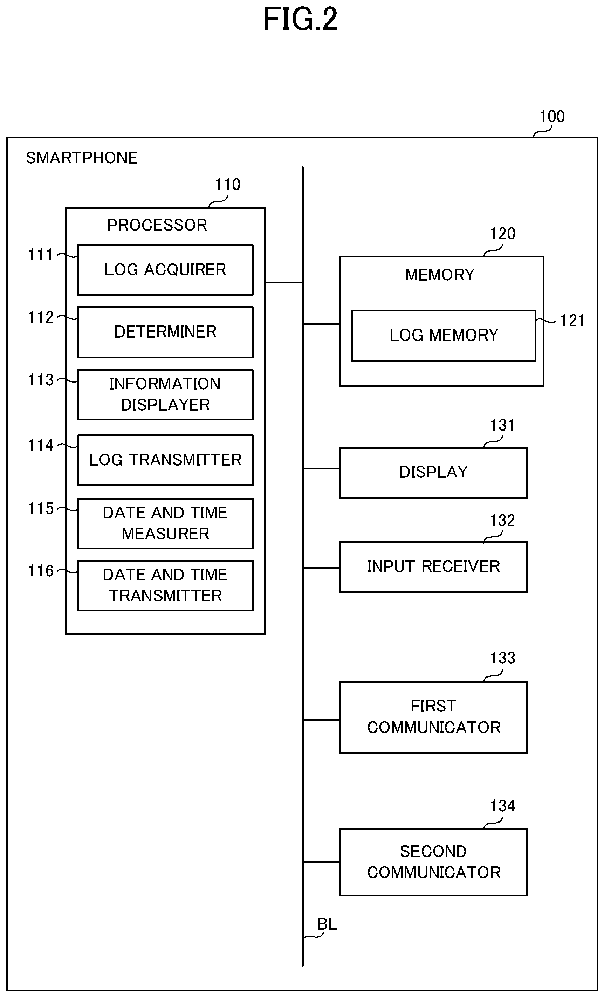

Hereinafter, the functional configuration of the smartphone 100 according to the present embodiment is described. The smartphone 100 is an electronic apparatus that displays information related to the electronic timepiece 200. As illustrated in FIG. 2, the smartphone 100 includes a processor 110, a memory 120, a display 131, an input receiver 132, a first communicator 133, and a second communicator 134. These components are electrically connected to each other via a bus line BL.

The processor 110 includes a processor such as a central processing unit (CPU) or the like, and reads and executes programs stored in the memory 120 to control the operations of the smartphone 100.

The memory 120 includes read-only memory (ROM) and random access memory (RAM). The memory 120 stores programs to be executed by the processor 110 and necessary data. Note that a portion or all of the ROM is rewritable non-volatile memory (flash memory or the like), and data that must remain stored after the power of the smartphone 100 is turned OFF is stored in this rewritable non-volatile memory. The memory 120 functionally includes a log memory 121.

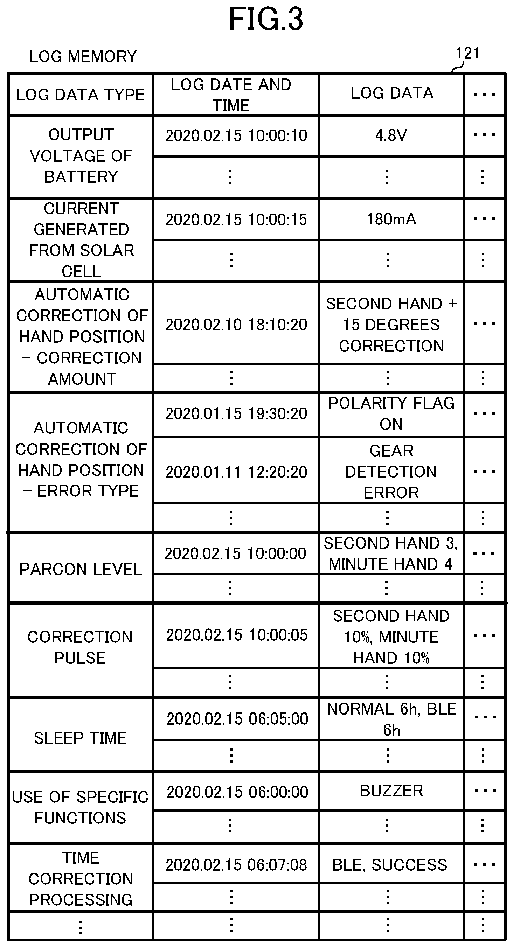

As illustrated in FIG. 3, the log memory 121 stores and accumulates the log data acquired from the electronic timepiece 200. FIG. 3 illustrates an example in which "output voltage of battery", "current generated from solar cell", "automatic correction of hand position - amount of correction", "automatic correction of hand position - error type", "ParCon level", "correction pulse", "sleep time", "use of specific functions", and "time correction processing" are listed as the types of the log data stored in the log memory 121. Provided that abnormalities of the electronic timepiece 200 can be detected, any data may be used as the log data. Accordingly, the log memory 121 may store other types of log data in addition to the types listed in FIG. 3, and need not store some or all of the types listed in FIG. 3. In the present embodiment, a storage period of these pieces of log data is fundamentally set to one year, and log data that is one year old or older is deleted from the log memory 121.

The log data for which the type of log data is "output voltage of battery" is log data in which the output voltage of the battery of the electronic timepiece 200 over the past year is stored. The most recent log data is stored every ten minutes, the log data is thinned as the log data becomes older, and the log data from one year ago is stored as log data per day. Log data that is one year old or older is deleted from the log memory 121.

Note that the "output voltage of battery" need not be a voltage value itself. For example, a case is possible in which the output power of the battery when fully charged is set to battery level 1, the value of the battery level is incremented by one for increasingly smaller voltage values, and the output voltage of the battery in a nearly empty state is defined as battery level 7. Thus, the values of the battery levels may be regarded as the log data corresponding to the "output voltage of battery."

The log data for which the type of log data is "current generated from solar cell" is log data in which the current output from a solar cell (solar battery) mounted in the electronic timepiece 200 over the past year is stored. As with the "output voltage of battery" described above, the most recent log data is stored every ten minutes, the log data is thinned as the log data becomes older, and the log data from one year ago is stored as log data per day. Log data that is one year old or older is deleted from the log memory 121.

As with the "output voltage of battery", the "current generated from solar cell" need not be a current value itself. For example, a case is possible in which a maximum output current of the solar cell is set to generation level 10, the value of the generation level is incremented by one for increasingly smaller current values, and 0 mA is defined as generation level 0. Thus, the values of the generation levels may be regarded as the log data corresponding to the "current generated from solar cell."

The log data for which the type of the log data is "automatic correction of hand position - amount of correction" is log data in which a date and time at which a hand position automatic correction function of the electronic timepiece 200 is executed, the hand corrected at that time, and an amount of correction are stored.

The log data for which the type of log data is "automatic correction of hand position - error type" is log data in which the type of abnormality when an abnormality occurs in the motor (pulse motor) or the wheelwork mechanism (gears) that move the hands of the electronic timepiece 200 is stored. For example, since the pulse motor that moves the hands of the electronic timepiece 200 is configured such that the polarity of the pulse motor inverts every one second, the polarity of the pulse motor should be the same when moved two seconds. However, the polarity may be different due to strong surrounding magnetism or the like, even when moved two seconds. In such a case, an error type called "polarity flag ON" is stored in the log data. Additionally, a hole is provided in the gear that moves the hands of the electronic timepiece 200, and light that passes through the hole is detected to enable the detection of one rotation of the gear. However, it may be impossible to detect one rotation of the gear if an object is stuck in the gear or when affected by strong magnetism. In such a case, an error type called "gear detection error" is stored in the log data.

The log data for which the type of the log data is "ParCon level" is log data in which a ParCon level expressing the magnitude of a current applied to the pulse motor that moves the hands of the electronic timepiece 200 is periodically stored. Note that, immediately after initialization, the electronic timepiece 200 drives the pulse motor at maximum ParCon level. The pulse motor is driven at a ParCon level one level higher (a ParCon level using less electricity than the previous level) upon confirmation that the hands move with drive pulses of a lower power consumption. By repeating confirmation, the pulse motor is driven at the lowest possible power consumption.

The log data for which the type of the log data is "correction pulse" is log data in which, a ratio, of a predetermined amount of time (for example, two hours), that a high current consumption pulse (correction pulse) is used to move the hands of the electronic timepiece 200 is periodically stored. Typically, the ParCon level is lowered (the current is increased) when the hands do not move. However, the correction pulse is used when the hands do not move regardless of the ParCon level having been lowered to the lowest level (the ParCon level with the maximum current being used).

The log data for which the type of log data is "sleep time" is log data in which an amount of time that the electronic timepiece 200 has slept is stored. Note that there are two types of sleep time, namely a normal sleep time expressing an amount of time that the electronic timepiece 200 has been in a normal sleep state, and a BLE sleep time expressing an amount of time that only the short-range communicator 233 (described below) has been in a sleep state. Both of these sleep times are stored in the log memory 121.

The log data for which the type of the log data is "use of specific functions" is log data in which use histories of functions of the electronic timepiece 200 that consume a comparatively large amount of power (for example, light, buzzer, tide functions, and the like; hereinafter referred to as "specific functions") are stored.

Log data for which the type of the log data is "time correction processing" is log data in which content of time correction processing over the past year of the electronic timepiece 200 is stored. In some cases, the time correction processing succeeds (the correct time is acquired and the time is corrected to that time), and in some cases, the time correction processing fails (the correct time cannot be acquired and the time cannot be corrected). In cases in which the time correction processing succeeds one or more times in one day, the time of the time correction processing at which the processing first succeeded is stored. In cases in which all time corrections performed in the course of one day fail, the time of the final time correction failure is stored. This log data is not stored for days on which the time correction processing is not performed. Log data that is one year old or older is deleted from the log memory 121. Not only the success or the failure of the time correction processing, but also the means (global positioning system (GPS), standard radio waves, or connection to the smartphone via BLE) used for the time correction processing is stored in the log data. When a plurality of means is used, all of the used means are stored.

The display 131 includes a display such as a liquid crystal display (LCD), an electroluminescence (EL) display, or the like, and displays information to be notified to the user.

The input receiver 132 includes a touch panel, an operation button, or the like. The input receiver 132 is an input receiving device (an input interface) that receives input commands from the user.

The first communicator 133 is a BLE wireless module that includes an antenna. The first communicator 133 is for communicating with the electronic timepiece 200. The first communicator 133 sends and receives information to and from the electronic timepiece 200 in accordance with control by the processor 110.

The second communicator 134 is a wireless module that includes an antenna. The second communicator 134 is for communicating with the server 300. In one example, the second communicator 134 is implemented as a wireless module for carrying out wireless communication based on LTE (registered trademark) or a wireless local area network (LAN), and sends and receives information to and from the server 300 in accordance with control by the processor 110.

Next, the functional configuration of the processor 110 of the smartphone 100 is described. By executing the programs stored in the memory 120, the processor 110 operates as a log acquirer 111, a determiner 112, an information displayer 113, a log transmitter 114, a date and time measurer 115, and a date and time transmitter 116.

The log acquirer 111 acquires the log data from the electronic timepiece 200 and accumulates the acquired log data in the log memory 121. The log acquirer 111 acquires the log data from the electronic timepiece 200 when the smartphone 100 is connected by BLE to the electronic timepiece 200 via the first communicator 133. However, when the electronic timepiece 200 is connected continuously to the smartphone 100 for an extended period of time (for example, when the electronic timepiece 200 is constantly connected to the smartphone 100), the log acquirer 111 periodically (for example, one time per day) acquires the log data. Regardless of whether or not there is a constant connection, there are two types of times at which the smartphone 100 connects to the electronic timepiece 200 by BLE. These two types of times are when the user manually connects the electronic timepiece 200 to the smartphone 100, and when the electronic timepiece 200 automatically connects to the smartphone 100 to perform automatic time correction.

The determiner 112 determines, on the basis of the log data stored in the log memory 121, the statuses of the battery, the solar cell, the hand position correction, and the like of the electronic timepiece 200. Processings that are carried out by the determiner 112 for determining these statuses are described later.

The information displayer 113 displays, on the basis of the statuses of the electronic timepiece 200 determined by the determiner 112, information to be notified to the user on the display 131.

The log transmitter 114 transmits the log data stored in the log memory 121 to the server 300 via the second communicator 134.

The date and time measurer 115 measures the current date and time. While not illustrated in the drawings, the smartphone 100 includes one or more of a function for communicating with an LTE (registered trademark) base station, a function for receiving GPS radio waves, and a function for receiving standard radio waves. The smartphone 100 uses these functions to periodically acquire the accurate current date and time. Moreover, the date and time measurer 115 uses the accurate date and time acquired by these functions to measure current dates and times with little error.

The date and time transmitter 116 transmits the date and time measured by the date and time measurer 115 to the electronic timepiece 200 via the first communicator 133 when the electronic timepiece 200 is connected to the smartphone 100 to carry out time correction.

The configuration of the smartphone 100 according to Embodiment 1 is described above.

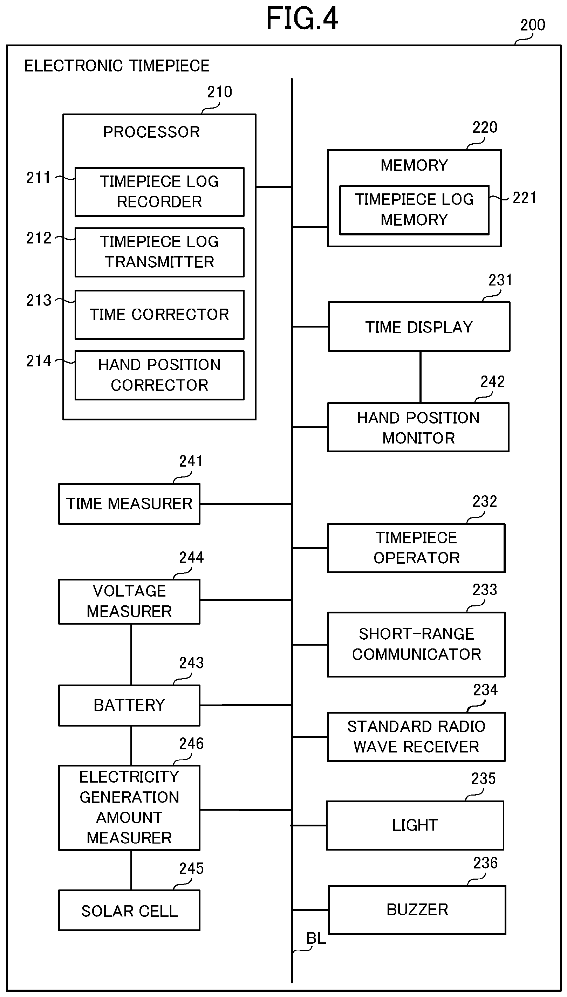

Next, the functional configuration of the electronic timepiece 200 according to Embodiment 1 is described. The electronic timepiece 200 is an analog battery-powered wristwatch, and is capable of communicating with the smartphone 100 by BLE. Note that the electronic timepiece 200 is not limited to an analog wristwatch. That is, the electronic timepiece 200 may be any battery-powered device that has a function of displaying time (time display device). As illustrated in FIG. 4, the electronic timepiece 200 includes a processor 210, a memory 220, a time display 231, a timepiece operator 232, a short-range communicator 233, a standard radio wave receiver 234, a light 235, a buzzer 236, a time measurer 241, a hand position monitor 242, a battery 243, a voltage measurer 244, a solar cell 245, and an electricity generation amount measurer 246. These components are electrically connected via a bus line BL.

The processor 210 includes a processor such as a CPU, and executes programs stored in the memory 220 to control the operations of the electronic timepiece 200.

The memory 220 includes a ROM and a RAM. The memory 220 stores programs to be executed by the processor 210 and necessary data. Note that a portion of all of the ROM is rewritable non-volatile memory (flash memory or the like), and data that must remain stored after the power of the electronic timepiece 200 is turned OFF is stored in this rewritable non-volatile memory. The memory 220 functionally includes a timepiece log memory 221.

The timepiece log memory 221 stores the log data of the electronic timepiece 200 using a timepiece log recorder 211 that is described later. This log data is log data that is similar to the log data stored in the log memory 121 of the smartphone 100, but differs in that, while the storage period of the log data stored in the log memory 121 is one year, the storage period of the log data stored in the timepiece log memory 221 is one month.

The log data for which the type of the log data is the "output voltage of battery" is log data of the output voltage of the battery 243, and the log data for which the type of the log data is the "current generated from solar cell" is log data of the current generated from the solar cell 245. As in the description of the log memory 121, these pieces of log data need not be voltage values and current values themselves. For example, the values of the battery levels may be used instead of voltage values as the log data, and the values of the generation levels may be used instead of current values as the log data. For these pieces of log data, the most recent log data is stored every ten minutes, and log data that is one day old or older is thinned to log data of every eight hours and stored. The thinning of these pieces of log data is performed so that the log data in which the maximum value for those eight hours is recorded remains.

As described above, the storage period of the log data stored in the timepiece log memory 221 is one week and, as such, log data that is one week old or older is deleted from the timepiece log memory 221. Note that this storage period is merely given by way of example and, for example, the storage period may be shortened (for example, to three days) in the case of an electronic timepiece 200 anticipated to be used while being continuously connected to the smartphone 100, or the storage period may be lengthened (for example, to one month) in the case of an electronic timepiece 200 anticipated to be used without frequently connecting to the smartphone 100.

The time display 231 includes a motor driver, a motor, a wheelwork mechanism, hands (second hand, minute hand, hour hand), a date indicator, a display driver, and a display (LCD or organic EL display). The time display 231 displays the current time and date. Note that, of the components of the time display 231, a set consisting of the hands and the mechanisms that move the hands (the motor, the wheelwork mechanism, and the like) is collectively referred to as an analog block.

The timepiece operator 232 includes a winding crown, a push button switch, and the like. The user operates the winding crown, the push button switch, and the like to cause the electronic timepiece 200 to perform time correction, connect to the smartphone 100, and the like.

The short-range communicator 233 is a BLE wireless module that includes an antenna. The short-range communicator 233 is for communicating with the smartphone 100. The short-range communicator 233 sends and receives information to and from the smartphone 100 in accordance with the control by the processor 210. In addition to sending the log data to the smartphone 100 via the short-range communicator 233, the electronic timepiece 200 can receive date and time information measured by the smartphone 100 and perform time correction.

The standard radio wave receiver 234 receives standard radio waves. The electronic timepiece 200 can acquire the current time by receiving standard radio waves by the standard radio wave receiver 234. Note that the electronic timepiece 200 may further include a GPS receiver that receives radio waves sent from a GPS satellite. In a case in which the electronic timepiece 200 includes the GPS receiver, the electronic timepiece 200 can acquire information about the position and time at the current location by receiving, by the GPS receiver, the radio waves sent from the GPS satellite.

The light 235 includes a light (LED, EL, or the like) that illuminates the time display 231 so that the user can confirm the time, even in dark places. Additionally, the buzzer 236 includes an electronic buzzer for sounding an alarm sound.

The time measurer 241 includes a timekeeping circuit. The time measurer 241 measures the current date and time and outputs the measured results to the processor 210. The processor 210 performs time keeping processing for updating, on the basis of the measured results input from the time measurer 241, information about the current time stored in the memory 220, and displays the current time on the time display 231. Note that the functions of the time measurer 241 may be realized by the processor 210.

The hand position monitor 242 monitors whether there is a shift between the time indicated by the various hands (second hand, minute hand, hour hand) of the time display 231 and the current time measured by the time measurer 241. If there is a shift, the hand position monitor 242 informs a hand position corrector 214 that is described later. This monitoring does not need to be constantly continuously performed, and the monitoring may be performed periodically. In one example, shifts between each of the second, minute, and hour of the current time and the second, minute, and hour indicated by the hands of the time display 231 are monitored at a periodic interval such as one time per minute for the second hand, one time per hour for the minute hand, and one time per day for the hour hand.

The battery 243 is a rechargeable secondary battery that supplies power to the electronic timepiece 200.

The voltage measurer 244 measures the output voltage of the battery 243. Voltage values measured by the voltage measurer 244 are output to the timepiece log recorder 211 that is described later.

The solar cell 245 is a solar cell that, when irradiated with light, supplies power for charging the battery 243.

The electricity generation amount measurer 246 measures the amount of electricity generated (generated current) by the solar cell 245. The current generated by the solar cell 245 is used to charge the battery 243 and, as such, the amount of generated electricity is equal to the value of the charging current when charging the battery 243. The current value measured by the electricity generation amount measurer 246 is output to the timepiece log recorder 211 that is described later.

Next, the functional configuration of the processor 210 of the electronic timepiece 200 is described. The processor 210 functionally includes a timepiece log recorder 211, a timepiece log transmitter 212, a time corrector 213, and a hand position corrector 214.

The timepiece log recorder 211 stores the value of the output voltage of the battery 243 measured by the voltage measurer 244, the value of the current generated from the solar cell 245 measured by the electricity generation amount measurer 246, time correction results of the time corrector 213, hand position correction results of the hand position corrector 214, and the like in the timepiece log memory 221.

The timepiece log transmitter 212 transmits the log data stored in the timepiece log memory 221 to the smartphone 100 via the short-range communicator 233.

The time corrector 213 performs manual time correction processing according to a user command from the timepiece operator 232, and periodic automatic time correction processing (for example, by starting up the time correction processing at a predetermined time every day). Regardless of being manual or automatic, the time correction processing is carried out by connecting to the smartphone 100 or receiving the standard radio waves to acquire the accurate current date and time.

If the hand position corrector 214 receives a notification from the hand position monitor 242 that the positions of the hands have shifted, the hand position corrector 214 corrects the positions of the hands to positions that indicate the correct current time.

The configuration of the electronic timepiece 200 according to Embodiment 1 is described above. Note that, while not described in detail herein, in addition to the functions described above, the electronic timepiece 200 includes, as functions that consume a comparatively large amount of power (specific functions), a function for turning ON a light that illuminates the time display 231 by the light 235, a function for outputting an alarm sound by the buzzer 236 at an alarm set time, a time function for calculating high tide times and low tide times using tide data acquired from the smartphone 100, and the like.

Next, the server 300 according to Embodiment 1 is described. The server 300 is a computer that is capable receiving the log data from the smartphone 100 and storing the received log data by connecting to the smartphone 100 via the network 400.

The server 300 is capable of communicating with a plurality of smartphones 100 and, as such, can receive log data from a plurality of electronic timepieces 200. As such, log data is stored by an identification (ID) of the electronic timepiece 200. With the exception of the log data being stored by the ID of the electronic timepiece 200, the content of the log data stored in the server 300 is the same as that stored in the log memory 121 of the smartphone 100. However, since the storage capacity of the memory of the server 300 is typically larger than the storage capacity of the memory 120 of the smartphone 100, the log data may be stored for a longer storage period than that of the log memory 121. For example, a configuration is possible in which the server 300 stores the "output voltage of battery" and the "current generated from solar cell" from over the past few years.

The configuration of the server 300 according to Embodiment 1 is described above. Next, processings in which the smartphone 100 determines the statuses of the electronic timepiece 200 and, as necessary, notifies the user of information are described one at a time.

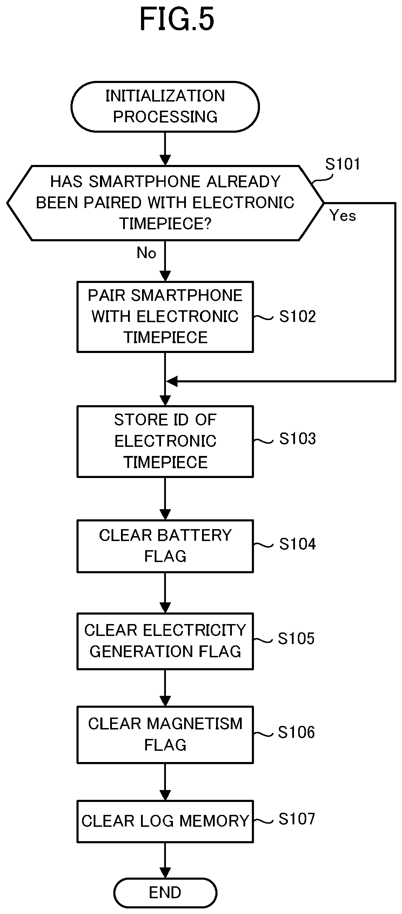

Initialization processing
Firstly, initialization processing for connecting the electronic timepiece 200 to the smartphone 100 by BLE, and enabling the smartphone 100 to ascertain the statuses of the electronic timepiece 200 is described while referencing FIG. 5. This processing is only performed one time, when the user purchases the electronic timepiece 200, as work for registering the electronic timepiece 200 with the smartphone 100. In one example, the initialization processing is provided as application software for a smartphone, and the initialization processing starts when the user starts up the application software.

Firstly, the processor 110 determines whether or not the electronic timepiece 200 and the smartphone 100 have already been paired (step S101). The term "pairing" means registering information to establish a communication connection between devices that are to communicate with each other over Bluetooth (registered trademark). If the smartphone 100 and the electronic timepiece 200 have been paired in the past, it is possible to automatically connect on the basis of the information from the past pairing. As such, a determination can be made on the basis of this information as to whether or not the smartphone 100 and the electronic timepiece 200 have already been paired. If the smartphone 100 and the electronic timepiece 200 have already been paired (step S101; Yes), the processing proceeds to step S103.

If the smartphone 100 and the electronic timepiece 200 have not already been paired (step S101; No), the processor 110 carries out pairing with the electronic timepiece 200 (step S102). At this time, if this pairing is the first pairing with the electronic timepiece 200, the processor 110 registers the date and time of the pairing in the memory 120.

Upon completion of the pairing, the processor 110 acquires the ID of the electronic timepiece 200 and stores the acquired ID in the memory 120 (step S103).

Next, the processor 110 clears a "battery flag" to 0 (step S104). The battery flag is a variable stored in the memory 120. Additionally, the processor 110 clears an "electricity generation flag" to 0 (step S105). The electricity generation flag is a variable stored in the memory 120. Moreover, the processor 110 clears a "magnetism flag" to 0 (step S106). The magnetism flag is a variable stored in the memory 120. Furthermore, the processor 110 clears the entirety of the log memory 121 to 0 (step S107), and ends the initialization processing.

Note that the variable "battery flag" is a flag expressing whether or not there is a possibility that the battery of the electronic timepiece 200 is degraded. If the determiner 112 determines that there is no possibility that the battery of the electronic timepiece 200 is degraded, the variable "battery flag" is cleared to 0, and if the determiner 112 determines that there is a possibility that the battery of the electronic timepiece 200 is degraded, the variable "battery flag" is set to 1.

The variable "electricity generation flag" is a flag expressing whether or not there is a possibility that the solar cell of the electronic timepiece 200 is degraded. If the determiner 112 determines that there is no possibility that the solar cell of the electronic timepiece 200 is degraded, the variable "electricity generation flag" is cleared to 0, and if the determiner 112 determines that there is a possibility that the solar cell of the electronic timepiece 200 is degraded, the variable "electricity generation flag" is set to 1.

The variable "magnetism flag" is a flag expressing whether or not there is a possibility that an abnormality has occurred in the analog block of the electronic timepiece 200 due to the effects of magnetism or the like. If the determiner 112 determines that there is no possibility that an abnormality has occurred in the analog block of the electronic timepiece 200, the variable "magnetism flag" is cleared to 0, and if the determiner 112 determines that there is a possibility that an abnormality has occurred in the analog block of the electronic timepiece 200, the variable "magnetism flag" is set to 1.

Note that, in step S104, the variable "battery flag" is cleared to 0, but a configuration is possible in which, in step S104, the variable "battery flag" is set to 1. By initially setting the variable "battery flag" to 1, the smartphone 100 will be more likely to notify the user of information about charging that is described later. Likewise, the variable "electricity generation flag" may be set to 1 in step S105.

The initialization processing described above prepares the smartphone 100 to determine the various statuses of the electronic timepiece 200 on the basis of future usage trends of the electronic timepiece 200.

### Log data acquisition processing

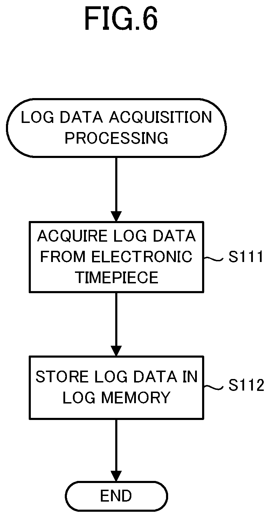

The initialization processing described above only prepares the smartphone 100 to make determinations about the various statuses of the electronic timepiece 200. The smartphone 100 must acquire the log data from the electronic timepiece 200 in order to make the determinations. As such, next, log data acquisition processing is described while referencing FIG. 6. Execution of the log data acquisition processing starts when the electronic timepiece 200 connects to the smartphone 100. However, in a case in which the smartphone 100 is continuously connected to the electronic timepiece 200 for an extended period of time, the log data acquisition processing is periodically executed (for example, one time per day).

In one example, the time correction processing and the log data acquisition processing are performed when the user connects the electronic timepiece 200 to the smartphone 100 in order to perform time correction of the electronic timepiece 200. At this time, the smartphone 100 may simultaneously execute the time correction processing and the log data acquisition processing as separate threads, or may execute one of the time correction processing and the log data acquisition processing first and, thereafter, execute the other. Additionally, in a case in which the electronic timepiece 200 is constantly connected to the smartphone 100, periodic log data acquisition is carried out by performing the log data acquisition processing at 7:00 AM every day, for example.

Firstly, the log acquirer 111 of the smartphone 100 acquires the log data from the electronic timepiece 200 via the first communicator 133 (step S111). Note that, while the smartphone 100 is executing step S111, the timepiece log transmitter 212 of the electronic timepiece 200 transmits the log data stored in the timepiece log memory 221 to the smartphone 100 via the short-range communicator 233.

Next, the log acquirer 111 of the smartphone 100 stores the acquired log data in the log memory 121 (step S112), and the log data acquisition processing is ended. Note that, in step S112, the log acquirer 111 deletes old log data (for example, the "output voltage of battery" that is one year old or older) and log data to be thinned that are stored in the log memory 121.
In one example, log data per every eight hours of the "output voltage of battery" from seven days ago to one day ago is transmitted from the electronic timepiece 200, but this data is thinned to log data per day. When the log acquirer 111 thins the log data of the "output voltage of battery" and the "current generated from solar cell", the thinning is carried out so that the log data in which the maximum value on that day is recorded remains.

As a result of the log data acquisition processing described above, the log data acquired from the electronic timepiece 200 is accumulated in the log memory 121, and the smartphone 100 is enabled to determine the various statuses of the electronic timepiece 200.

### Information display processing

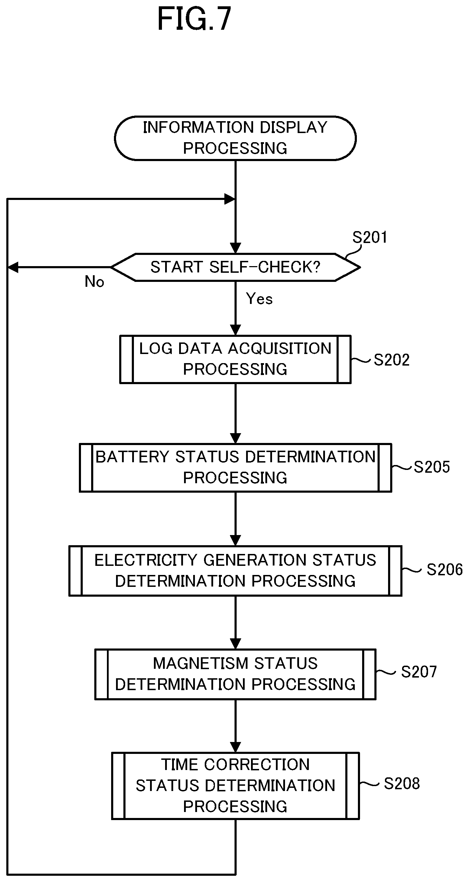

Next, information display processing is described while referencing FIG. 7. In the information display processing, the smartphone 100 makes determinations (self-checks) about the various statuses of the electronic timepiece 200, and displays determination results.

Execution of the information display processing starts when the user starts up the application software for starting the information display processing. A configuration is possible in which execution of the information display processing starts when the initialization processing (FIG. 5) described above ends.

When the information display processing starts, the processor 110 determines whether or not to start a self-check (status determination) (step S201). For example, if the user performs an input command via the input receiver 132 to command the start of the self-check, a determination of Yes is made and the self-check is manually started. That is, an input command from the user, received by the smartphone 100, serves as a trigger for starting the self-check. A configuration is possible in which a determination of Yes is made at a predetermined timing (for example, at a predetermined time (for example, 7:00 AM every day), after a predetermined amount of time (for example, 24 hours) has elapsed since the previous self-check), and the self-check starts automatically. A configuration is possible in which, after a manual self-check, the self-check is not started for a predetermined auto ignore period (for example, 24 hours).

If the processor 110 determines not to start the self-check (step S201; No), step S201 is executed. If the processor 110 determines to start the self-check (step S201; Yes), the log acquirer 111 performs the log data acquisition processing described above while referencing FIG. 6 (step S202).

Next, the determiner 112 performs battery status determination processing (step S205). Details of the battery status determination processing are described later. Then, the determiner 112 performs electricity generation status determination processing (steps S206). Details of the electricity generation status determination processing are described later.

Next, the determiner 112 performs magnetism status determination processing (step S207). Details of the magnetism status determination processing are described later. Then, the determiner 112 performs time correction status determination processing (step S208) and, then, executes step S201. Details of the time correction status determination processing are described later.

In each of the determination processings performed by the determiner 112, when it is determined that information to be notified to the user must be displayed, the information displayer 113 displays that information on the display 131. Hereinafter, details of the various determination processings performed by the determiner 112 are described one at a time.

To facilitate comprehension, in the description of each processing, battery levels 1 to 7 are used as the log data of the "output voltage of battery", and generation levels 10 to 0 are used as the log data of the "current generated from solar cell." Here, battery level 1 corresponds to the output voltage when the battery 243 is fully charged, and battery level 7 corresponds to the output voltage when the battery 243 is nearly empty. Generation level 10 corresponds to the current generated when sunlight hits the solar cell 245 outside on a sunny day, and generation level 0 corresponds to the current generated when no sunlight whatsoever hits the solar cell 245. Generation level 5 corresponds to generated current roughly the same as the current consumed when the electronic timepiece 200 is normally operating, and generation level 7 corresponds to the current generated in an environment directly under a fluorescent light. In the following description, the minimum voltage for battery level 5 is set as a voltage reference value, the minimum current for generation level 5 is set as an equilibrium electricity generation reference value, and the minimum current for generation level 7 is set as a normal electricity generation reference value. Note that these level values and reference values are merely examples and may be changed to more suitable values as appropriate.

To facilitate comprehension, in the description of each processing, it is described that the period for which the status is determined is set to "one month", but this period (status determination reference period) is not limited to one month.

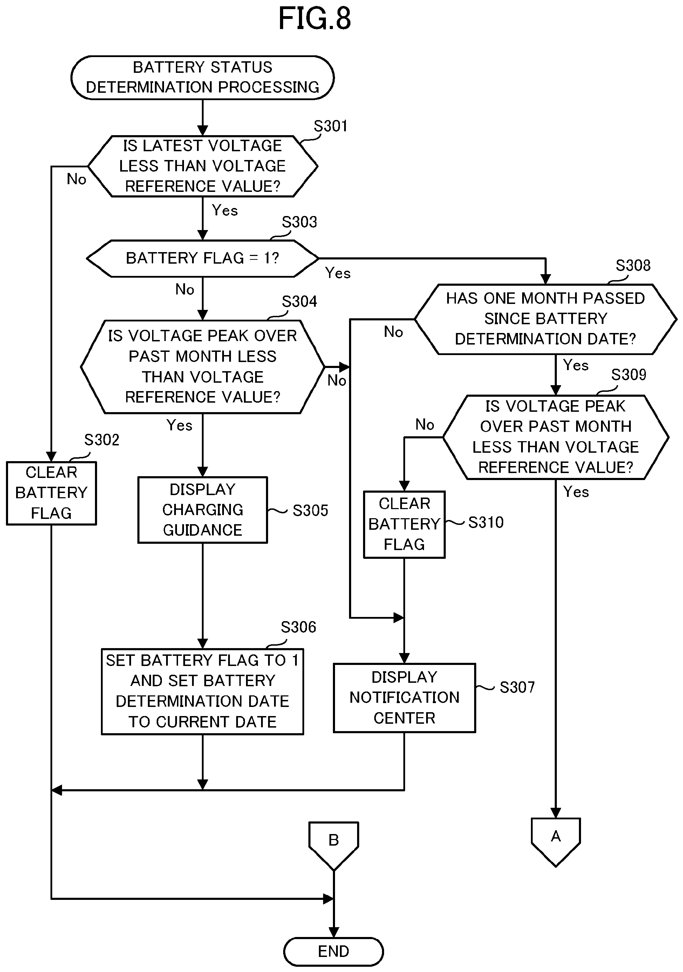

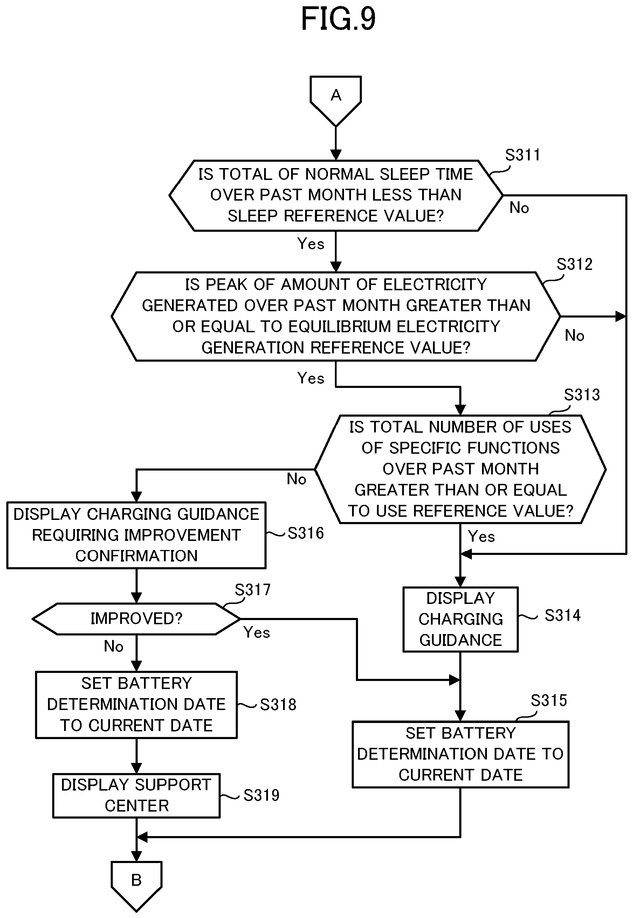

Firstly, the battery status determination processing executed in step S205 of FIG. 7 is described while referencing FIGS. 8 and 9.

In the battery status determination processing, firstly, the determiner 112 of the smartphone 100 references the log memory 121 and determines whether or not the value of the latest (most recent) "output voltage of battery" is less than the voltage reference value (step S301). In this case, the phrase "the value of the log data of the 'output voltage of battery' is less than the voltage reference value" means that the battery level recorded as the log data is 6 or 7.

If the value of the latest log data of the "output voltage of battery" is greater than or equal to the voltage reference value (step S301; No), the processor 110 clears the variable "battery flag" to 0 (step S302), and ends the battery status determination processing. If the value of the latest log data of the "output voltage of battery" is less than the voltage reference value (step S301; Yes), the determiner 112 determines whether or not the value of the variable "battery flag" is 1 (step S303).

If the value of the variable "battery flag" is not 1 (step S303; No), the determiner 112 references the log memory 121 and determines whether or not the peak value in the log data over the past month of the "output voltage of battery" is less than the voltage reference value (step S304).

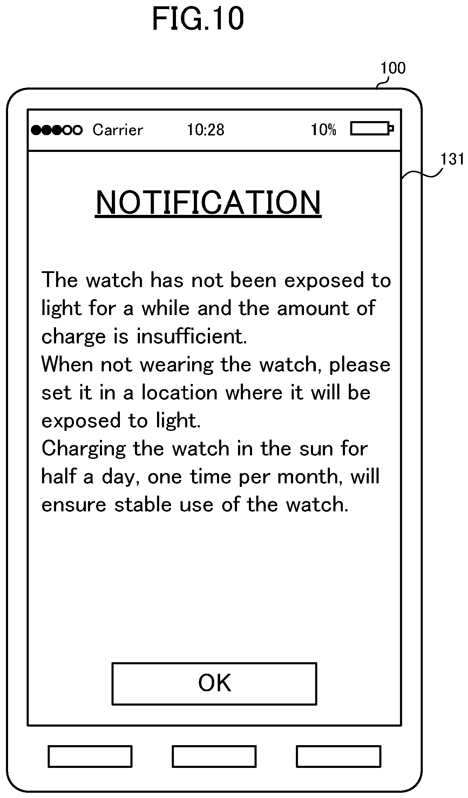

If the peak value in the log data over the past month of the "output voltage of battery" is less than the voltage reference value (step S304; Yes), the information displayer 113 displays a charging guidance on the display 131 (step S305). The charging guidance is, as illustrated in FIG. 10, a screen that notifies that the amount of charge is insufficient and provides advice (first information) for favorable charging. Additionally, the processor 110 sets the variable "battery flag" to 1 and sets the variable "battery determination date" to a current date (date on which the electronic timepiece 200 is connected to the smartphone 100) (step S306), and ends the battery status determination processing.

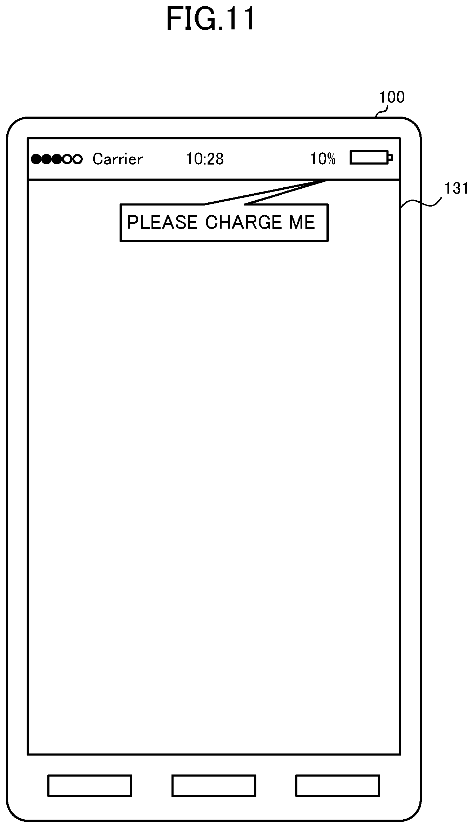

Meanwhile, in step S304, if the peak value in the log data over the past month of the "output voltage of battery" is greater than or equal to the voltage reference value (step S304; No), the information displayer 113 performs a display of a notification center corresponding to the value of the latest log data of the "output voltage of battery" (step S307), and the battery status determination processing is ended. Here, the display of the notification center is, as illustrated in FIG. 11, a display of a message in an upper portion of the screen of the smartphone 100. Note that FIG. 11 illustrates an example in which a message "Please charge me", which corresponds to battery level 7, is displayed. When the value of the latest log data of the "output voltage of battery" is battery level 6, the content of the message in the display of the notification center is "Please charge me soon."

Meanwhile, in step S303, if the value of the variable "battery flag" is 1 (step S303; Yes), the determiner 112 determines whether or not one month or longer has passed from the date set as the variable "battery determination date" to the current date (step S308). If one month or longer has not passed (step S308; No), the information displayer 113 performs a display of a notification center corresponding to the value of the latest log data of the "output voltage of battery" (step S307), and the processor 110 ends the battery status determination processing.

If one month or longer has passed from the date set as the variable "battery determination date" to the current date (step S308; Yes), the determiner 112 references the log memory 121 and determines whether or not the peak value in the log data over the past month of the "output voltage of battery" is less than the voltage reference value (step S309). If the peak value in the log data over past month is greater than or equal to the voltage reference value (step S309; No), the processor 110 clears the variable "battery flag" to 0 (step S310), the information displayer 113 performs a display of a notification center corresponding to the value of the latest log data of the "output voltage of battery" (step S307), and the battery status determination processing is ended.

If the peak value in the log data over the past month is less than the voltage reference value (step S309; Yes), the processing proceeds to step S311 of FIG. 9. In step S311, the determiner 112 references the log memory 121, aggregates the log data for the past month of the "sleep time", and determines whether or not the total hours of the normal sleep over the past month is less than a sleep reference value (for example, 400 hours).

If the total hours of the normal sleep over the past month is greater than or equal to the sleep reference value (step S311; No), the information displayer 113 performs a display of a charging guidance on the display 131 (step S314). Additionally, the processor 110 sets the variable "battery determination date" to the current date (date on which the electronic timepiece 200 is connected to the smartphone 100) (step S315), and ends the battery status determination processing.

If the total hours of normal sleep over the past month is less than the sleep reference value (S311; Yes), the determiner 112 references the log memory 121 and determines whether or not the peak value in the log data over the past month of the "current generated from solar cell" is greater than or equal to the equilibrium electricity generation reference value (step S312). In this case, the phrase "the value of the log data of the 'current generated from solar cell' is greater than or equal to the equilibrium electricity generation reference value" means that the generation level stored as log data is 5 or greater. That is, the phrase "the peak value of the log data over the past month of the 'current generated from solar cell' is less than the equilibrium electricity generation reference value" means that the solar cell did not generate an amount of electricity that corresponds to the normal power consumption of the electronic timepiece 200.

If the peak value in the log data over the past month of the "current generated from solar cell" is less than the equilibrium electricity generation reference value (step S312; No), step S314 is executed and the processing described above is carried out.

If the peak value in the log data over the past month of the "current generated from solar cell" is greater than or equal to the equilibrium electricity generation reference value (step S312; Yes), the determiner 112 references the log memory 121 and determines whether or not a total number of uses of the specific functions (light, buzzer, tide function, and the like) over the past month is greater than or equal to a use reference value (for example, 180 times) (step S313).

If the total number of uses of the specific functions over the past month is greater than or equal to the use reference value (step S313; Yes), step S314 is executed and the processing described above is carried out.

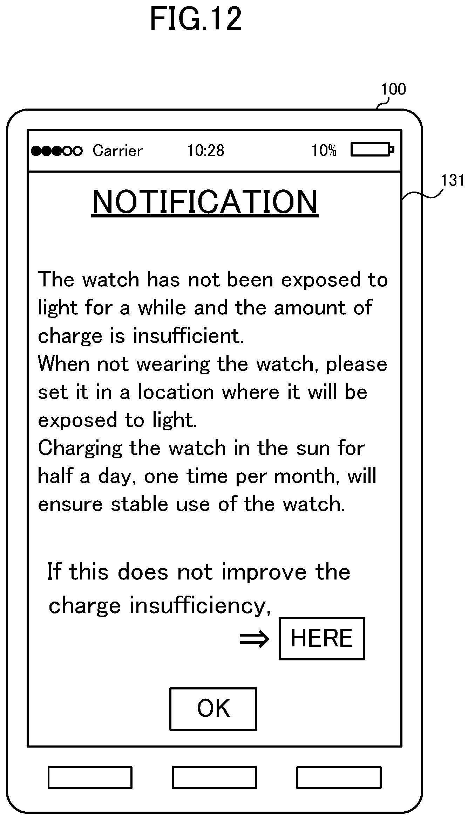

If the total number of uses of the specific functions over the past month is less than the use reference value (step S313; No), the information displayer 113 performs a display of a charging guidance requiring an improvement confirmation on the display 131 (step S316), and waits for an input (in this case, a touch of "Here" or "OK") from the user about whether or not there is improvement. This input can be acquired through a touch panel of the input receiver 132. The charging guidance requiring an improvement confirmation is, as illustrated in FIG. 12, a screen for displaying advice for favorable charging and for confirming whether or not the insufficiency of the amount of charge has improved.

Then, the processor 110 determines whether or not the input from the user is "Improved" (a touch of "OK") (step S317). If the input from the user is "Improved" (that is, a touch of "OK") (step S317; Yes), the processor 110 sets the variable "battery determination date" to the current date (date on which the electronic timepiece 200 is connected to the smartphone 100) (step S315), and ends the battery status determination processing.

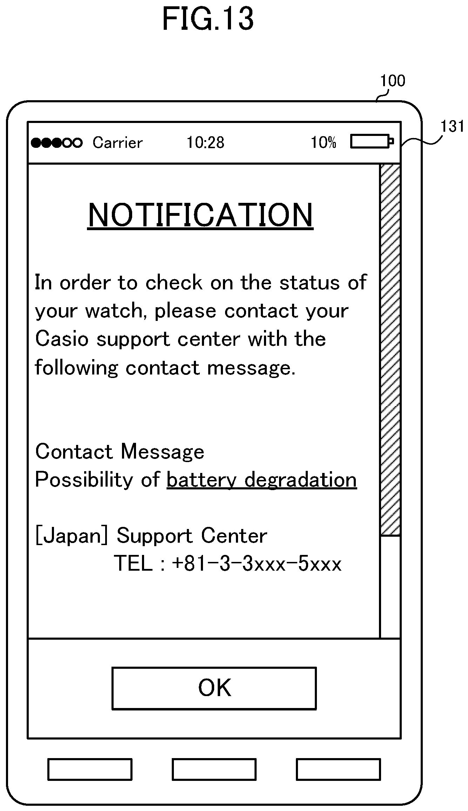

If the input from the user is "Not improved" (that is, a touch of "Here") (step S317; No), the processor 110 sets the variable "battery determination date" to the current date (date on which the electronic timepiece 200 is connected to the smartphone 100) (step S318), the information displayer 113 performs a display of support center information about battery degradation on the display 131 (step S319), and the battery status determination processing is ended. The "support center information about battery degradation" is information (second information) such as illustrated in FIG. 13 that indicates the possibility of battery degradation and presents contact information of a support center.

The battery status determination processing is described above. This battery status determination processing enables the smartphone 100 to display advice information for favorably charging in cases in which the amount of charge of the electronic timepiece 200 is insufficient for an extended period of time. Additionally, if the amount of charge of the electronic timepiece 200 is still insufficient for an extended period of time after the displaying of the advice information, the smartphone 100 outputs a message for confirming whether or not the insufficiency of the amount of charge improved and, if a response is acquired indicating that the insufficiency of the amount of charge is not improved, the user can be notified of the possibility of battery degradation.

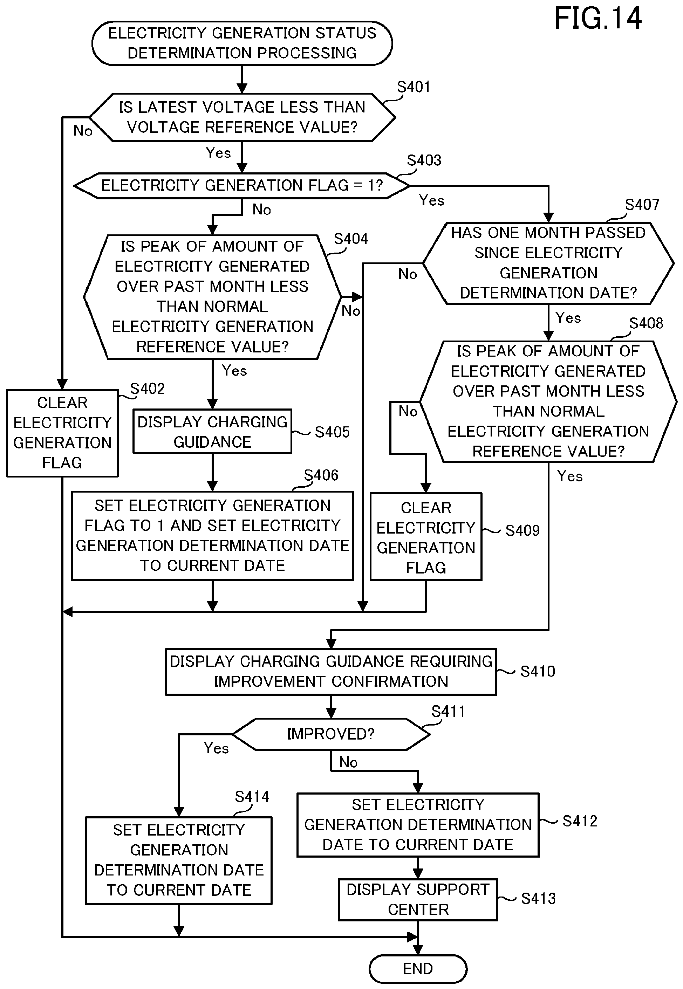

Note that, in cases in which the smartphone 100 has not been able to acquire the log data of the electronic timepiece 200 for one month or longer (status determination reference period) (in cases in which the previous log acquisition date is one month (status determination reference period) old or older), it is highly possible that an accurate determination cannot be made about the status of the battery of the electronic timepiece 200. Accordingly, in such a case, the entire battery status determination processing may be skipped (the battery status determination processing may be ended without any processing). Next, the electricity generation status determination processing executed in step S206 of FIG. 7 is described while referencing FIG. 14.

In the electricity generation status determination processing, firstly, the determiner 112 of the smartphone 100 references the log memory 121 and determines whether or not the value of the latest (most recent) "output voltage of battery" is less than the voltage reference value (step S401). In this case, the phrase "the value of the log data of the 'output voltage of battery' is less than the voltage reference value" means that the battery level recorded as the log data is 6 or 7.

If the value of the latest log data of the "output voltage of battery" is greater than or equal to the voltage reference value (step S401; No), the processor 110 clears the variable "electricity generation flag" to 0 (step S402), and ends the electricity generation status determination processing. If the value of the latest log data of the "output voltage of battery" is less than the voltage reference value (step S401; Yes), the determiner 112 determines whether or not the value of the variable "electricity generation flag" is 1 (step S403).

If the value of the variable "electricity generation flag" is not 1 (step S403; No), the determiner 112 references the log memory 121 and determines whether or not the peak value in the log data over the past month of the "current generated from solar cell" is less than a normal electricity generation reference value (step S404). In this case, the phrase "the value of the log data of the 'current generated from solar cell' is less than the normal electricity generation reference value" means that the generation level stored as log data is less than 7. That is, the phrase "the peak value of the log data over the past month of the 'current generated from solar cell' is less than the normal electricity generation reference value" means that the solar cell 245 is not even able to generate current that corresponds to an environment always directly under a fluorescent light.

If the peak value in the log data over the past month of the "current generated from solar cell" is greater than or equal to the normal electricity generation reference value (step S404; No), the processor 110 ends the electricity generation status determination processing.

If the peak value in the log data over the past month of the "current generated from solar cell" is less than the normal electricity generation reference value (step S404; Yes), the information displayer 113 performs a display of a charging guidance such as illustrated in FIG. 10 on the display 131 (step S405). Then, the processor 110 sets the variable "electricity generation flag" to 1 and sets the variable "electricity generation determination date" to the current date (date on which the electronic timepiece 200 is connected to the smartphone 100) (step S406), and ends the electricity generation status determination processing.

Meanwhile, in step S403, if the value of the variable "electricity generation flag" is 1 (step S403; Yes), the determiner 112 determines whether or not one month or longer has passed from the date set as the variable "electricity generation determination date" to the current date (step S407). If one month or longer has not passed (step S407; No), the processor 110 ends the electricity generation status determination processing.

If one month or longer has passed from the date set as the variable "electricity generation determination date" to the current date (step S407; Yes), the determiner 112 references the log memory 121 and determines whether or not the peak value in the log data over the past month of the "current generated from solar cell" is less than the normal electricity generation reference value (step S408). If the peak value in the log data over the past month of the "current generated from solar cell" is greater than or equal to the normal electricity generation reference value (step S408; No), the processor 110 clears the variable "electricity generation flag" to 0 (step S409) and ends the electricity generation status determination processing.

If the peak value in the log data over the past month of the "current generated from solar cell" is less than the normal electricity generation reference value (step S408; Yes), the information displayer 113 performs a display of a charging guidance requiring an improvement confirmation such as illustrated in FIG. 12 on the display 131 (step S410), and waits for an input (in this case, a touch of "Here" or "OK") from the user about whether or not there is improvement. This input can be acquired through the touch panel of the input receiver 132.

Then, the processor 110 determines whether or not the input from the user is "Improved" (touch of "OK") (step S411). If the input from the user is "Improved" (that is, a touch of "OK") (step S411; Yes), the processor 110 sets the variable "electricity generation determination date" to the current date (date on which the electronic timepiece 200 is connected to the smartphone 100) (step S414), and ends the electricity generation status determination processing.

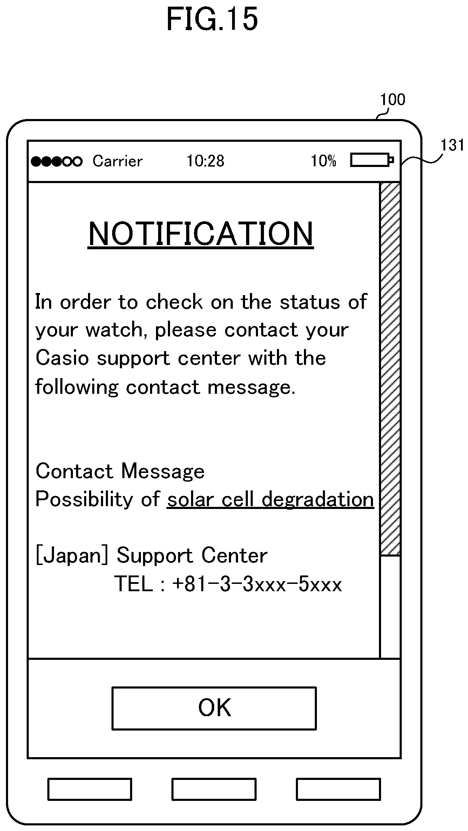

If the input from the user is "Not improved" (that is, a touch of "Here") (step S411; No), the processor 110 sets the variable "electricity generation determination date" to the current date (date on which the electronic timepiece 200 is connected to the smartphone 100) (step S412), the information displayer 113 performs a display of support center information about solar cell degradation on the display 131 (step S413), and the electricity generation status determination processing is ended. The "support center information about solar cell degradation" is information such as illustrated in FIG. 15 that indicates the possibility of solar cell degradation and presents contact information of a support center.

The electricity generation status determination processing is described above. This electricity generation status determination processing enables the smartphone 100 to display advice information for favorably charging in cases in which the amount of charge of the electronic timepiece 200 is insufficient for an extend period of time. Additionally, if the amount of charge of the electronic timepiece 200 is still insufficient for an extended period of time after the displaying of the advice information, the smartphone 100 displays the message for confirming whether or not the insufficiency of the amount of charge improved and, if a response is acquired indicating that the insufficiency of the amount of charge is not improved, the user can be notified of the possibility of solar cell degradation.

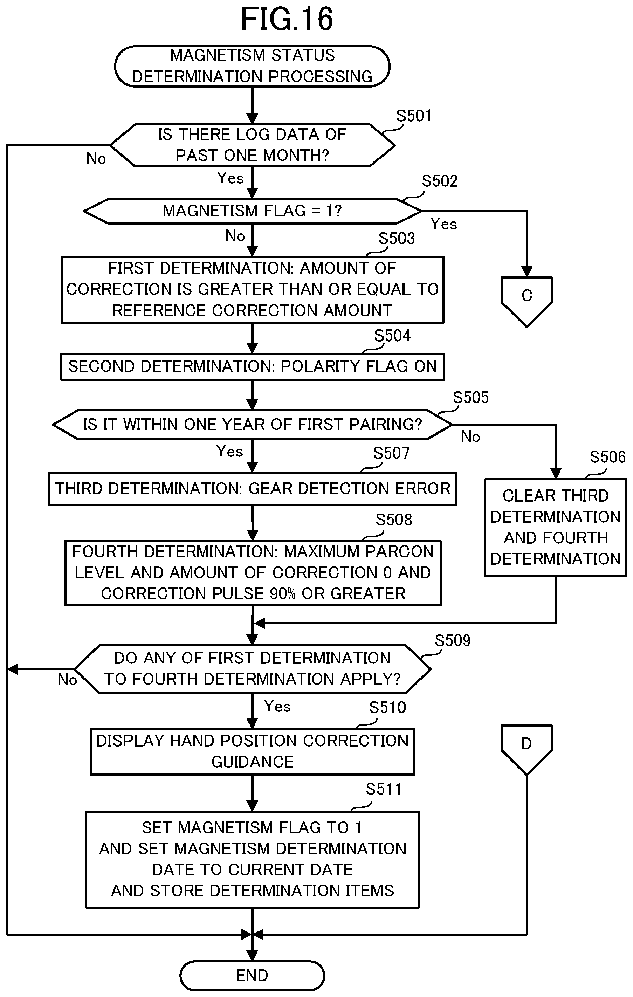

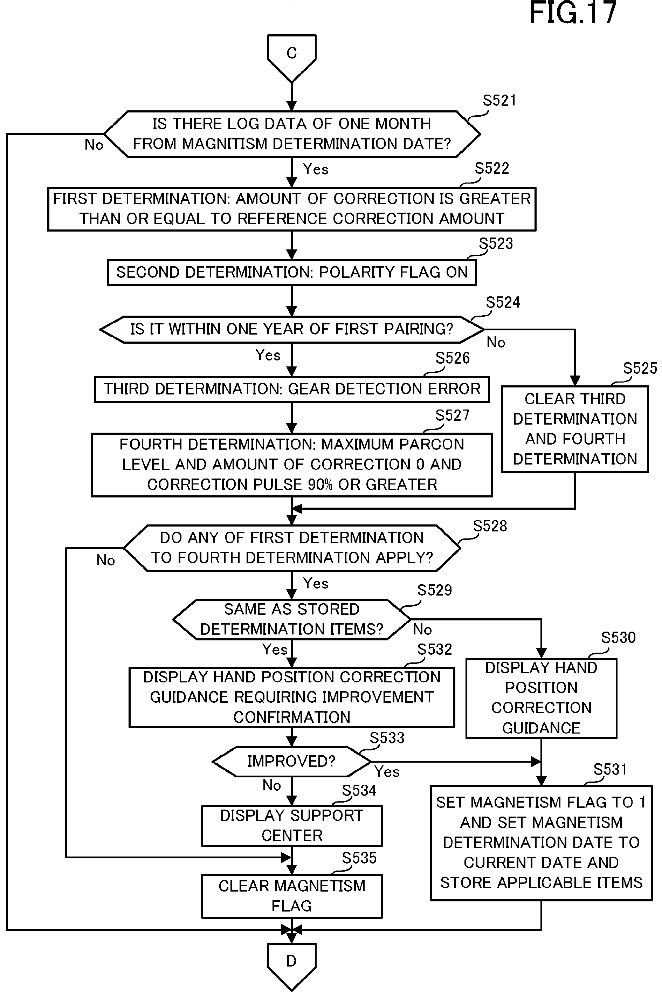

Note that, in cases in which the smartphone 100 has not been able to acquire the log data of the electronic timepiece 200 for one month or longer (status determination reference period) (in cases in which the previous log acquisition date is one month (status determination reference period) old or older), it is highly possible that an accurate determination cannot be made about the status of the solar cell of the electronic timepiece 200. Accordingly, in such a case, the entire electricity generation status determination processing may be skipped (the electricity generation status determination processing may be ended without any processing). Next, the magnetism status determination processing executed in step S207 of FIG. 7 is described while referencing FIGS. 16 and 17.

In the magnetism status determination processing, firstly, the determiner 112 of the smartphone 100 references the log memory 121 and determines whether or not log data of a past magnetism status determination reference period (in this case, the latest one month) or longer has been accumulated (step S501). If log data of the magnetism status determination reference period or longer has not been accumulated (step S501; No), the magnetism status determination processing is ended.

If log data of the magnetism status determination reference period or longer has been accumulated (step S501; Yes), the determiner 112 determines whether or not the value of the variable "magnetism flag" is 1 (step S502). If the value of the variable "magnetism flag" is not 1 (step S502; No), the determiner 112 references the log memory 121 and, as a first determination, determines whether or not automatic hand position correction, for which the amount of correction of the automatic hand position correction is greater than or equal to a reference correction amount (for example, 5), has periodically (for example, every day, every week, every morning, or the like) occurred in the log data of the past magnetism status determination reference period of the "automatic correction of hand position - amount of correction" (step S503), and stores the determination results as a variable "first determination." Although it is possible to set any value as the reference correction amount, in, for example, a case in which the angle of the hands are 5 degrees or greater out of place (and, as such, are corrected 5 degrees or greater by automatic correction), the reference correction amount can be set so that the amount of correction is greater than or equal to the reference correction amount.

Next, as a second determination, the determiner 112 determines whether or not a phenomenon in which a polarity flag turns ON (the polarity of the pulse motor inverts) has periodically (for example, every day, every week, every morning, or the like) occurred in the log data of the past magnetism status determination reference period of the "automatic correction of hand position - error type" (step S504), and stores the determination results as a variable "second determination."

Next the determiner 112 compares the current date and time with the date and time of the first pairing stored in the memory 120 to determine whether or not the current date and time is within a second magnetism status determination reference period (for example, one year) from the first pairing (step S505). If the current date and time is not within the second magnetism status determination reference period from the first pairing (step S505; No), the determiner 112 clears the variable "third determination" and the variable "fourth determination" to 0 (indicating NO) (step S506), and the processing proceeds to step S509.

If the current date and time is within the second magnetism status determination reference period from the first pairing (step S505; Yes), as a third determination, the determiner 112 determines whether or not a gear detection error (error in which normal rotation of a gear cannot be confirmed) has periodically (for example, every day, every week, every morning, or the like) occurred in the log data of the past magnetism status determination reference period of the "automatic correction of hand position - error type" (step S507), and stores the determination results as a variable "third determination."

Then, as a fourth determination, the determiner 112 determines whether or not a status in which the ParCon level is maximum, the automatic correction amount is 0, and the correction pulse is greater than or equal to a reference percentage (for example, 90%) has periodically (for example, every day, every week, every morning, or the like) occurred in the log data of the past magnetism status determination reference period of the "ParCon level", the "automatic correction of hand position - amount of correction", and the "correction pulse" (step S508), and stores the determination results as a variable "fourth determination."

Then, the determiner 112 determines whether or not any of the first determination to the fourth determination apply (whether any of the variables "first determination" to "fourth determination" are not 0) (step S509). If none of the first determination to the fourth determination apply (all of the variables "first determination" to "fourth determination" are 0) (step S509; No), the magnetism status determination processing is ended.

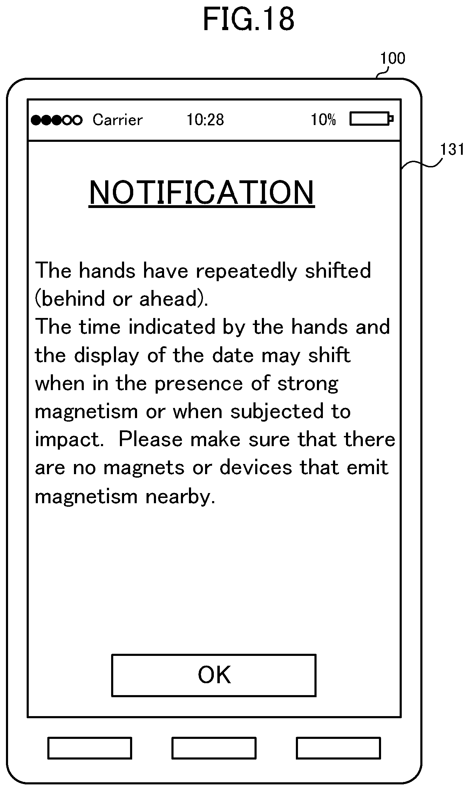

If any of the first determination to the fourth determination apply (step S509; Yes), the information displayer 113 performs a display of a hand position correction guidance on the display 131 (step S510). The hand position correction guidance is, as illustrated in FIG. 18, a screen that provides a notification informing that the hands have shifted and advice (third information) about preventing shifting of the hands. Note that, in the processing described above, a flow is described in which each of the first determination to the fourth determination is carried out sequentially. However, this is merely an example. For example, a configuration is possible in which the processing proceeds to step S509 immediately at the point in time at which any one of the first determination to the fourth determination is found to be true (any one of the variables "first determination" to "fourth determination" is 1).

Then, the processor 110 sets the variable "magnetism flag" to 1, sets the variable "magnetism determination date" to the current date (date on which the electronic timepiece 200 is connected to the smartphone 100), and stores the variables "first determination" to "fourth determination" in the memory 120 (step S511), and ends the magnetism status determination processing.

Meanwhile, in step S502, if the value of the variable "magnetism flag" is 1 (step S502; Yes), the processing proceeds to step S521 of FIG. 17, and the determiner 112 references the log memory 121 and determines whether or not log data of the magnetism status determination reference period or longer from the date set as the variable "magnetism determination date" has been accumulated.

If log data of the magnetism status determination reference period or longer from the date set as the variable "magnetism determination date" has not been accumulated (step S521; No), the magnetism status determination processing is ended.

If log data of the magnetism status determination reference period or longer from the date set as the variable "magnetism determination date" has been accumulated (step S521; Yes), the processing proceeds to step S522. The processing from step S522 to step S528 is the same as the processing of step S503 to step S509 of FIG. 16 and, as such, description thereof is omitted. Note that, as in step S503 to step S509, a configuration is possible in which, for example, the processing proceeds to step S528 immediately at the point in time at which any one of the first determination to the fourth determination is found to be true (any one of the variables "first determination" to "fourth determination" is 1).

In step S528, if none of the first determination to the fourth determination apply (all of the variables "first determination" to "fourth determination" are 0) (step S528; No), the processing proceeds to step S535.

If any of the first determination to the fourth determination apply (step S528; Yes), the determiner 112 determines whether or not the current first determination to the fourth determination are the same as the determination items stored in step S511 (whether or not the values of the variables "first determination" to "fourth determination" and the values of the past variables "first determination" to "fourth determination" stored in step S511 are the same) (step S529).

If the current first determination to the fourth determination are not the same as the determination items stored in step S511 (step S529; No), the information displayer 113 performs a display of the hand position correction guidance on the display 131 (step S530). Then, the processor 110 sets the variable "magnetism flag" to 1, sets the variable "magnetism determination date" to the current date (date on which the electronic timepiece 200 is connected to the smartphone 100), and stores the variables "first determination" to "fourth determination" in the memory 120 (step S531), and ends the magnetism status determination processing.

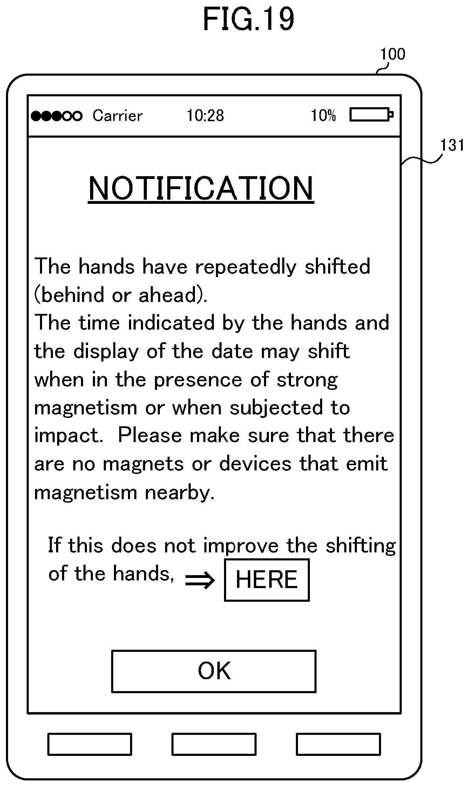

If the first determination to the fourth determination are the same as the determination items stored in step S511 (step S529; Yes), the information displayer 113 performs a display of a hand position correction guidance requiring an improvement confirmation on the display 131 (step S532), and waits for an input (in this case, a touch of "Here" or "OK") from the user about whether or not there is improvement. This input can be acquired through the touch panel of the input receiver 132. The hand position correction guidance requiring an improvement confirmation is, as illustrated in FIG. 19, a screen for notifying that the hands have shifted, displaying advice for preventing shifting of the hands, and for confirming whether or not the shifting of the hands improved.

Then, the processor 110 determines whether or not the input from the user is "Improved" (a touch of "OK") (step S533). If the input from the user is "Improved" (that is, a touch of "OK") (step S533; Yes), the processing proceeds to step S531.

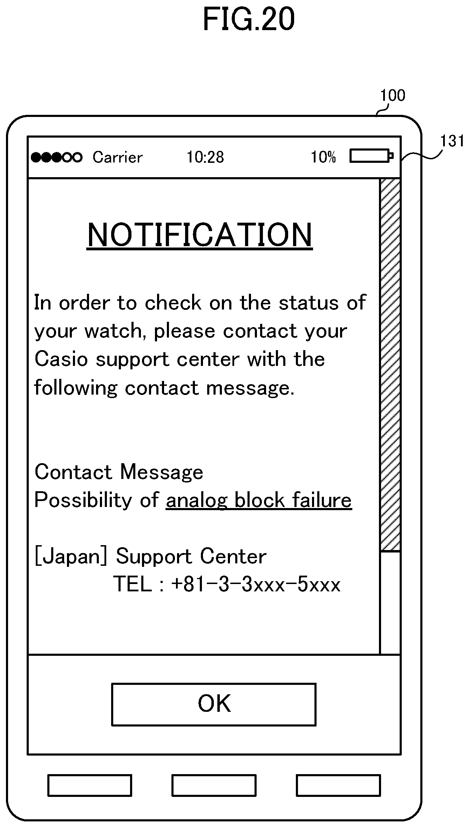

If the input from the user is "Not improved" (that is, a touch of "Here") (step S533; No), the information displayer 113 performs a display of support center information about analog block failure on the display 131 (step S534). The "support center information about analog block failure" is information (fourth information) such as illustrated in FIG. 20 that indicates the possibility of analog block failure and presents contact information of a support center. Then, the processor 110 clears the variable "magnetism flag" to 0 (step S535) and ends the magnetism status determination processing.

The magnetism status determination processing is described above. This magnetism status determination processing enables the smartphone 100 to display advice information for preventing shifting of the hands in cases in which the hand positions of the electronic timepiece 200 frequently shift. Additionally, in cases in which there is an abnormality in the operations of the hands of the electronic timepiece 200 even after the advice information has been displayed, depending on the determination results, it is possible to display the advice information again, display a message for confirming whether or not the shifting of the hands improved, and the like. Moreover, if a response is acquired indicating that the shifting of the hands is not improved, it is possible to notify that there is a possibility of analog block failure.

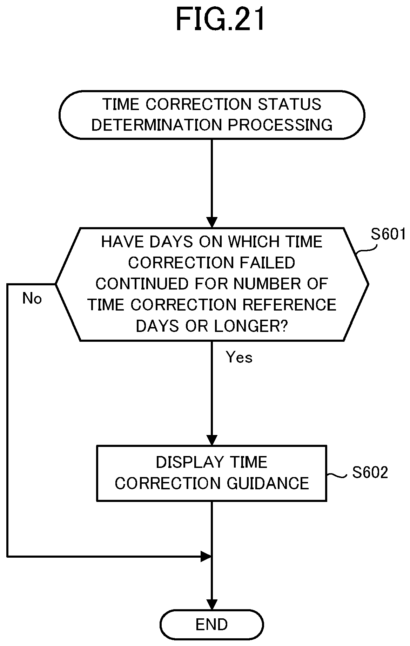

Next, the time correction status determination processing executed in step S208 of FIG. 7 is described while referencing FIG. 21. Firstly, the determiner 112 of the smartphone 100 references the log memory 121 and determines, from the log data of the "time correction processing", whether or not days on which time correction failed have continued for a number of time correction reference days (for example, one week) or longer (step S601). If the time correction has succeeded over less than the number of time correction reference days in the past (step S601; No), the processor 110 ends the time correction status determination processing.

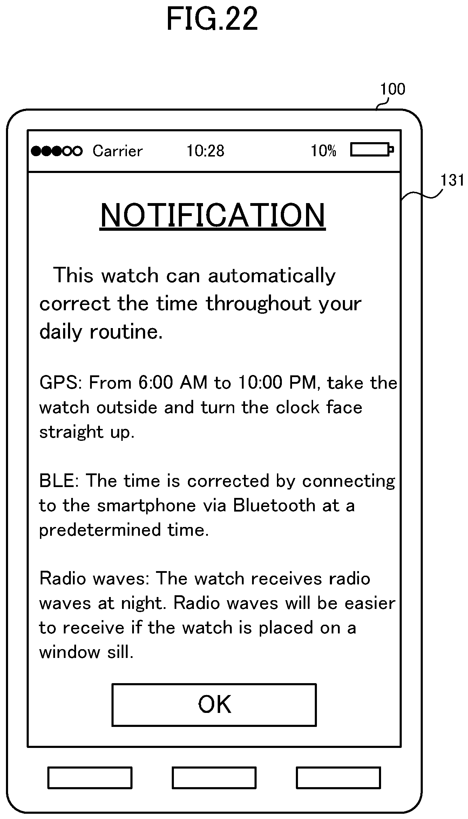

If the days on which time correction failed have continued for the number of time correction reference days or longer (step S601; Yes), the information displayer 113 performs a display of a time correction guidance on the display 131 (step S602). The time correction guidance is a screen such as illustrated in FIG. 22 that provides a notification of advice for correctly performing the time correction. Then, the processor 110 ends the time correction status determination processing.

The time correction status determination processing described above enables the smartphone 100 to display advice information for correctly performing the time correction in cases in which the time correction processing of the electronic timepiece 200 frequently fails.

Each of the various status determination processings executed in the various steps of the information display processing illustrated in FIG. 7 is described above. As described above, the information display processing enables the smartphone 100 to determine whether or not there is an abnormality of the electronic timepiece 200 at the desired timing of the user, and display appropriate information corresponding to the determination results. Additionally, the processor 110 performs the log data acquisition processing when the start of the self-check is commanded and, as such, can perform the self-check of the electronic timepiece 200 on the basis of the latest log data. Although there are electronic timepieces that determine, at a specific timing, whether or not there is an abnormality, this specific timing does not necessarily match the timing at which the user desires to determine whether or not there is an abnormality. Accordingly, in a case in which the timing at which the user desires to determine whether or not there is an abnormality and the specific timing do not match, the user must wait for the specific timing, even if the user desires to immediately determine whether or not there is an abnormality. According to the present disclosure, a determination of whether or not there is an abnormality of a timepiece can be made at a desired timing of a user.

A configuration is possible in which, in step S201 of FIG. 7, the self-check starts automatically at a predetermined timing (for example, at a predetermined time (for example, 7:00 AM every day), after a predetermined amount of time (for example, 24 hours) has elapsed since the previous self-check, or the like), without the user commanding the start of the self-check by providing an input command through the input receiver 132. As a result of such a configuration, the user can periodically ascertain the various statuses of the electronic timepiece 200 without performing special operations.

Additionally, a configuration is possible in which in step S201 of FIG. 7, after a manual self-check by the user, the self-check does not automatically start for a predetermined auto ignore period (for example, 24 hours). As a result of such a configuration, it is possible to prevent depletion of the batteries of the smartphone 100 and the electronic timepiece 200 caused by the performance of various determinations, which the user does not need, by automatic self-checks.

The electronic timepiece 200 is an analog timepiece and, in the case of analog timepieces, there is a concern of problems occurring in the operation of the hands due to magnetism, impact, and the like. For example, in cases in which the electronic timepiece 200 is subjected to strong impact such as when dropped or when colliding with another object, the user can manually start a self-check and, as a result, can immediately inspect whether or not a problem has occurred in the analog block due to that impact.

Additionally, in the battery status determination processing (FIG. 9) described above, in cases in which, in step S313, the total number of uses of the specific functions is greater than or equal to the use reference value, charging guidance without an improvement confirmation is displayed. Due to this, displays suggesting that there are problems in the battery 243 or the solar cell 245 can be prevented, even when the battery 243 of the electronic timepiece 200 is depleted due to the user frequently using functions that consume a comparatively large amount of power.

In the magnetism status determination processing described above, the first determination to the fourth determination are carried out to display guidances and the like for the first time in cases in which the possibility is very high that a problem has occurred in the analog block or the like. As such, it is possible to avoid making the user unnecessarily anxious.

Note that, in the information display processing illustrated in FIG. 7, the guidance about charging (the battery), the guidance about magnetism (operation of the hands), and the guidance about time correction (time adjustment) are displayed, but these are merely examples and the guidances to be displayed are not limited thereto.

### Alternative Example of Embodiment 1

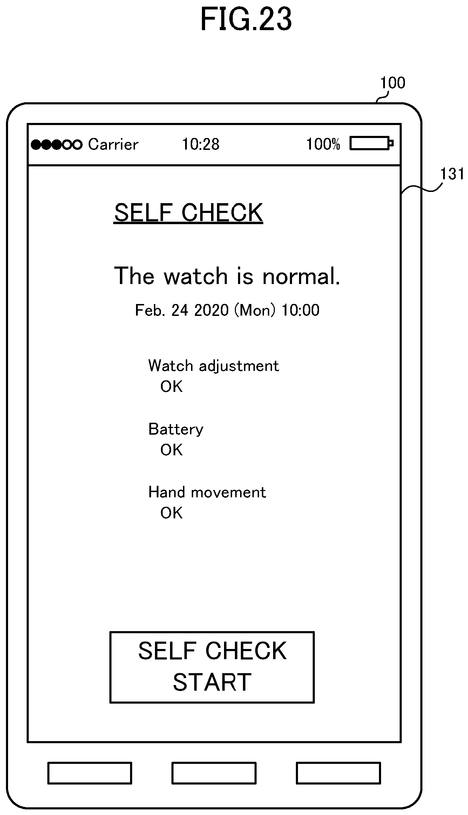

In the embodiment described above, each guidance is displayed individually. However, a configuration is possible in which, prior to displaying the guidances individually, the various determination results (time adjustment, battery, movement of hands) of the electronic timepiece 200 are displayed in a list as illustrated in FIG. 23 and, then, details about items suspected to be abnormalities are displayed. Next, an alternative example of Embodiment 1, which is an example in which the determination results are displayed in a list, is described.

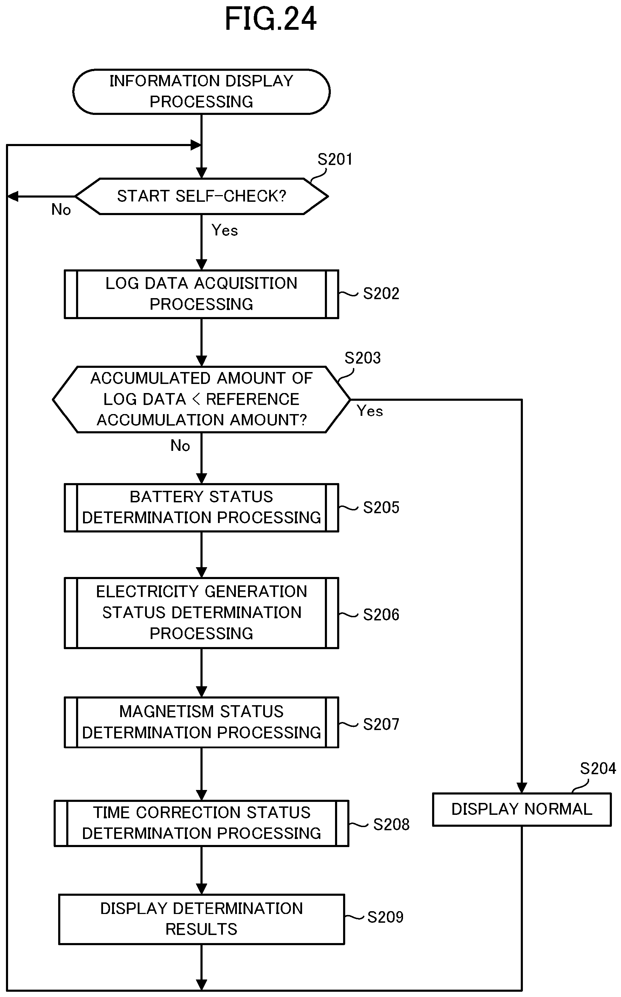

The configurations of the smartphone 100 and the electronic timepiece 200 according to the alternative example of Embodiment 1 are the same as in Embodiment 1 and, as such, description thereof is omitted. Information display processing is described while referencing FIG. 24. In the information display processing, the smartphone 100 according to the alternative example of Embodiment 1 makes determinations (self-checks) about the various statuses of the electronic timepiece 200, and displays determination results.

Except for a portion thereof, this information display processing is the same as the information display processing according to Embodiment 1 described while referencing FIG. 7. As such, the following description focuses on the different portion.

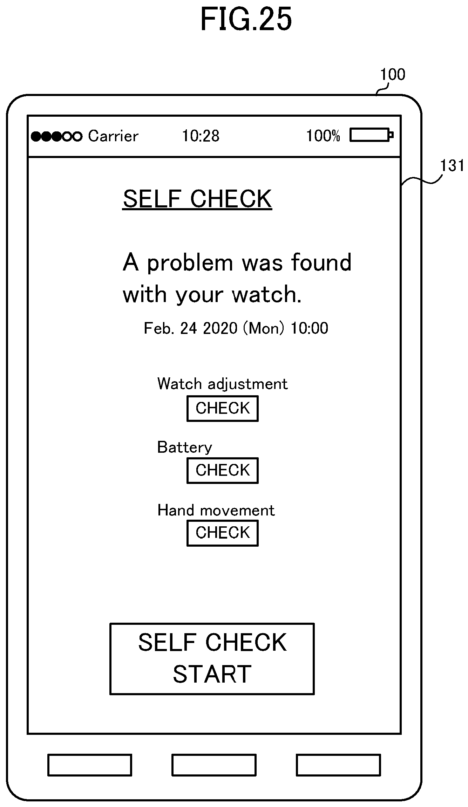

The timing at which the information display processing starts and the processing of step S201 and step S202 are the same as in the information display processing according to Embodiment 1. However, in the alternative example of Embodiment 1, a screen such as illustrated in FIG. 23 (a case in which an abnormality is suspected is illustrated in FIG. 25), for example, is displayed as a result of the information display processing and, when the user touches "SELF CHECK START" in this screen, the information display processing is started again.

Then, after step S202, the processor 110 determines whether or not an accumulated amount of log data stored in the log memory 121 is less than a reference accumulation amount (for example, one month of log data) (step S203).

If the accumulated amount of log data is less than the reference accumulation amount (step S203; Yes), the information displayer 113 displays, on the display 131, an indication such as illustrated in FIG. 23 that the electronic timepiece is normal (step S204), and executes step S201. If the accumulated amount of log data is greater than or equal to the reference accumulation amount (step S203; No), the processing proceeds to step S205.

The processing of step S205 to step S208 is fundamentally the same as in the information display processing according to Embodiment 1. However, in each of the determination processings, instead of the information displayer 113 performing displays of the various guidances and the like, the processor 110 stores, in the memory 120, determination results suspected to be abnormalities.

Then, after step S208, the information displayer 113 displays the determination results in a list on the basis of the determination results that the processor 110 stores in the memory 120 in each determination processing from step S205 to step S208 (step S209), and executes step S201. In step S209, it is preferable that the date and time when the determination is made is also displayed. Displaying the date and time when the determination is made enables the user to ascertain when what kind of self-check results of the electronic timepiece 200 are obtained.

For example, in a case in which there are no determination results suspected to be abnormalities, an indication that the electronic timepiece 200 is normal is displayed, as illustrated in FIG. 23. Additionally, in a case in which there is a determination result suspected to be an abnormality, an indication that there is a problem in the electronic timepiece 200 and a "CHECK" button for the item with the problem are displayed as illustrated in FIG. 25. The guidance display and the like for that item is displayed when the user touches "CHECK."

As described above, in the alternative example of Embodiment 1, prior to displaying each individual guidance, the determination results are displayed in a list. As such, the user can more easily ascertain if the electronic timepiece 200 is normal or abnormal and, if abnormal, more easily ascertain which item has a problem.

In cases in which the accumulated amount of log data is less than the reference accumulation amount, there is a high possibility that the processor 110 cannot accurately determine the various statuses. In such a case, the information displayer 113 displays an indication of normal without the determiner 112 performing the various determinations. As such, it is possible to prevent making the user anxious due to incorrect determinations being made.

Note that, in each determination processing (step S205 to step S208) of the information display processings illustrated in FIG. 7 and FIG. 24, if the determiner 112 determines that the electronic timepiece 200 is abnormal, the processor 110 may cause the input receiver 132 to not accept input commands in step S201 from the user during a subsequent predetermined ignore input period (for example, 24 hours). There is a high possibility that, until the cause of the abnormality is eliminated, the same determination results will be obtained when performing the determinations again. As such, configuring in this manner enables the prevention of performing useless determination processing. Additionally, the processor 110 may display the "SELF CHECK START" button illustrated in FIG. 23 and FIG. 25 grayed out during the ignore input period. As a result of this configuration, the user can be provided with an indication that input commands for the self-check are not being accepted.

This concludes the description of the embodiments. However, it should be noted that the embodiments described about are merely examples, and the configuration of the determination system 1000, the content of the processings, and the like are not limited to those described in the embodiments described above. For example, the messages displayed in the guidance displays may be appropriately changed. Additionally, the values described above and the values listed in FIG. 3 for the storage time intervals of the log data stored in the log memory 121, the timepiece log memory 221, and the server 300 are merely examples, and can be changed as appropriate.

A configuration is possible in which whether a time announcement function of the electronic timepiece 200 is used, whether an alarm function is used, the amount of time to output the alarm sound when using the alarm, the time when and the amount of time that the light is ON, the use of a GPS function, and the like may be recorded as the log data of the "use of specific functions." Moreover, it is possible to incorporate processing, in which these pieces of log data are used to more closely analyze usage patterns of the user, into each determination processing of the information display processing. As a result of such a configuration, the information of the guidance display when notifying the user of information can be made more detailed, easier to understand, and the like. Additionally, a configuration is possible in which the determination system 1000 includes any type of a battery-operated device instead of the electronic timepiece 200. In this case as well, the smartphone 100 can display charging guidances and the like about that device. Moreover, the log data and the guidance displays can be changed in accordance with the functions of that device.

In the embodiments described above, an example is described in which the processors 110 and 210 carry out control operations by CPUs. However, the control operations are not limited to software control by the CPUs. Part or all of the control operations may be realized using a hardware configuration such as a dedicated wired logic or the like. Additionally, each of the processors 110 and 210 may operate as the various components of the functional configurations described above using a single CPU, or may operate as the various components of the functional configurations using a plurality of CPUs.

In the embodiments described above, a description is given in which the programs to be executed by the processors 110 and 210 are stored in advance in the ROMs of the memories 120 and 220. However, a computer may be configured that is capable of realizing these various functions by storing and distributing the programs on a non-transitory computer-readable recording medium such as a universal serial bus (USB) memory, a flexible disk, a compact disc read-only memory (CD-ROM), a hard disk drive (HDD), a digital versatile disc (DVD), and a magneto-optical disc (MO), and reading out and installing these programs on the computer. Moreover, in cases in which the various functions are realized by being divided between an operating system (OS) and an application, or are realized by cooperation between an OS and an application, it is possible to store only the portion other than the OS on the non-transitory recording medium.

Furthermore, the various programs can be piggybacked on carrier waves and distributed via a communication network. For example, a configuration is possible in which the programs are uploaded to a bulletin board system (BBS) on a communication network, and are made downloadable from that network. Moreover, a configuration is possible in which the smartphone 100, the electronic timepiece 200, and the server 300 download and start up these programs and, under the control of the OS, execute the programs in the same manner as other applications/programs to enable the execution of each processing described above.

The foregoing describes some example embodiments for explanatory purposes. Although the foregoing discussion has presented specific embodiments, persons skilled in the art will recognize that changes may be made in form and detail without departing from the scope of the invention. Accordingly, the specification and drawings are to be regarded in an illustrative rather than a restrictive sense. This detailed description, therefore, is not to be taken in a limiting sense, and the scope of the invention is defined only by the included claims.

## Claims

1. An electronic apparatus (100) comprising at least one processor (110) and a display (131), wherein
the processor (110) is configured to
acquire, from a time display device (200), log data of the time display device (200), and
determine, based on the acquired log data and with an input command from a user received by the electronic apparatus (100) as a trigger, a status of whether the time display device (200) is abnormal,
**characterized in that**
the processor (110) is further configured to
display, on the display (131), information corresponding to the following determined status of the time display device (200),
determine whether there is an abnormality in an operation of a hand of the time display device (200) during a magnetism status determination reference period, and
display an information on the display (131) if a determination is made that there is an abnormality in the operation of the hand, and
in the determination of whether there is an abnormality in the operation of the hand, a determination is made that there is an abnormality in the operation of the hand if an occurrence of an abnormality is detected in one or more of
a first determination that is a determination of whether an abnormality periodically occurs, the abnormality being that an automatic correction amount of a hand position performed by the time display device (200) is greater than or equal to a reference correction amount,
a second determination that is a determination of whether an abnormality periodically occurs, the abnormality being that a polarity of a motor inverts in the time display device (200),
a third determination that is a determination of whether an abnormality periodically occurs, the abnormality being that a position detection of a gear in the time display device (200) is not possible within a second magnetic status determination reference period from a first pairing with the time display device (200), and
a fourth determination that is a determination of whether an abnormality periodically occurs, the abnormality being that the motor is driven at a maximum ParCon level, expressing the magnitude of a current applied to the pulse motor that moves the hands, in the time display device (200), also, the automatic correction amount of the hand position is 0 and, also, a correction pulse is generated at a percentage greater than or equal to a reference percentage within the second magnetic status determination reference period from the first pairing with the time display device (200),
when displaying said information on the display (131), store a determination that an occurrence of an abnormality is detected among the first determination to the fourth determination,
after displaying said information on the display (131), further determine whether there is an abnormality in the operation of the hand of the time display device (200) during the magnetism status determination reference period,
in a case in which a determination is made that there is an abnormality in the operation of the hand after displaying said information on the display (131) and even after the magnetism status determination reference period passes,
if the determination that an occurrence of an abnormality is detected after the magnetism status determination reference period passes
is identical to the stored determination, said information is displayed on the display (131), and
if different from the stored determination, a subsequent information is displayed on the display (131).

2. The electronic apparatus (100) according to claim 1, further comprising:
a memory (120), wherein
the processor (110) is configured to
acquire the log data of the time display device (200) from the time display device (200) and accumulate the acquired log data in the memory (120), and
determine, based on the log data accumulated in the memory (120) and with the input command received by the electronic apparatus (100) as the trigger, the status of whether the time display device (200) is abnormal.

3. The electronic apparatus (100) according to claim 1 or 2, further comprising:
an input receiving device (132) that receives the input command from the user, wherein
the processor (110) is configured to determine, based on the acquired log data and with the input command from the user received by the input receiving device (132) as the trigger, the status of whether the time display device (200) is abnormal.

4. The electronic apparatus (100) according to any one of claims 1 to 3, wherein
the processor (110) is configured to
acquire, based on the input command, the log data, and
determine, based on the acquired log data, the status of the time display device (200).

5. The electronic apparatus (100) according to claim 4, wherein
the processor (110) is configured to
determine that the time display device (200) is normal in a case in which, when the electronic apparatus (100) receives the input command, an accumulated amount of the log data does not satisfy a reference accumulation amount.

6. The electronic apparatus (100) according to any one of claims 1 to 5, wherein
the processor (110) is configured to
if a determination is made that the time display device (200) is abnormal, not accept the input command for a subsequent predetermined input ignore period.

7. The electronic apparatus (100) according to any one of claims 1 to 6, wherein
the processor (110) is configured to
automatically determine, at a predetermined timing, the status of whether the time display device (200) is abnormal, even without the input command.

8. The electronic apparatus (100) according to claim 7, wherein
the processor (110) is configured to
if the status of the time display device (200) is determined based on the input command, not automatically perform a determination of the status of the time display device (200) for a predetermined auto ignore period.

9. The electronic apparatus (100) according to any one of claims 1 to 8, wherein the time display device (200) is an analog timepiece.

10. The electronic apparatus (100) according to any one of claims 1 to 9, wherein the electronic apparatus (100) acquires the log data from the time display device (200) by wireless communication.

11. A determination system (1000), comprising a time display device (200) and an electronic apparatus (100), wherein
the electronic apparatus (100) includes at least one processor (110) and a display (131), and
the processor (110) is configured to
acquire, from the time display device (200), log data of the time display device (200), and
determine, based on the acquired log data and with an input command from a user received by the electronic apparatus (100) as a trigger, a status of whether the time display device (200) is abnormal
**characterized in that**
the processor (110) is further configured to
display, on the display (131), information corresponding to the following determined status of the time display device (200),
determine whether there is an abnormality in an operation of a hand of the time display device (200) during a magnetism status determination reference period, and
display an information on the display (131) if a determination is made that there is an abnormality in the operation of the hand, and
in the determination of whether there is an abnormality in the operation of the hand, a determination is made that there is an abnormality in the operation of the hand if an occurrence of an abnormality is detected in one or more of
a first determination that is a determination of whether an abnormality periodically occurs, the abnormality being that an automatic correction amount of a hand position performed by the time display device (200) is greater than or equal to a reference correction amount,
a second determination that is a determination of whether an abnormality periodically occurs, the abnormality being that a polarity of a motor inverts in the time display device (200),
a third determination that is a determination of whether an abnormality periodically occurs, the abnormality being that a position detection of a gear in the time display device (200) is not possible within a second magnetic status determination reference period from a first pairing with the time display device (200), and
a fourth determination that is a determination of whether an abnormality periodically occurs, the abnormality being that the motor is driven at a maximum ParCon level, expressing the magnitude of a current applied to the pulse motor that moves the hands, in the time display device (200), also, the automatic correction amount of the hand position is 0 and, also, a correction pulse is generated at a percentage greater than or equal to a reference percentage within the second magnetic status determination reference period from the first pairing with the time display device (200),
when displaying said information on the display (131), store a determination that an occurrence of an abnormality is detected among the first determination to the fourth determination,
after displaying said information on the display (131), further determine whether there is an abnormality in the operation of the hand of the time display device (200) during the magnetism status determination reference period,
in a case in which a determination is made that there is an abnormality in the operation of the hand after displaying said information on the display (131) and even after the magnetism status determination reference period passes,
if the determination that an occurrence of an abnormality is detected after the magnetism status determination reference period passes
is identical to the stored determination, said information is displayed on the display (131), and
if different from the stored determination, a subsequent information is displayed on the display (131).

12. A determination method of an electronic apparatus (100) comprising a display (131), the determination method comprising:
acquiring, from a time display device (200), log data of the time display device (200); and
determining, based on the acquired log data and with an input command from a user received by the electronic apparatus (100) as a trigger, a status of whether the time display device (200) is abnormal,
**characterized in that**
the determination method further comprising:
displaying, on the display (131), information corresponding to the following determined status of the time display device (200),
determining whether there is an abnormality in an operation of a hand of the time display device (200) during a magnetism status determination reference period, and
displaying an information on the display (131) if a determination is made that there is an abnormality in the operation of the hand, and
in the determination of whether there is an abnormality in the operation of the hand, a determination is made that there is an abnormality in the operation of the hand if an occurrence of an abnormality is detected in one or more of
a first determination that is a determination of whether an abnormality periodically occurs, the abnormality being that an automatic correction amount of a hand position performed by the time display device (200) is greater than or equal to a reference correction amount,
a second determination that is a determination of whether an abnormality periodically occurs, the abnormality being that a polarity of a motor inverts in the time display device (200),
a third determination that is a determination of whether an abnormality periodically occurs, the abnormality being that a position detection of a gear in the time display device (200) is not possible within a second magnetic status determination reference period from a first pairing with the time display device (200), and
a fourth determination that is a determination of whether an abnormality periodically occurs, the abnormality being that the motor is driven at a maximum ParCon level, expressing the magnitude of a current applied to the pulse motor that moves the hands, in the time display device (200), also, the automatic correction amount of the hand position is 0 and, also, a correction pulse is generated at a percentage greater than or equal to a reference percentage within the second magnetic status determination reference period from the first pairing with the time display device (200),
when displaying said information on the display (131), storing a determination that an occurrence of an abnormality is detected among the first determination to the fourth determination,
after displaying said information on the display (131), further determining whether there is an abnormality in the operation of the hand of the time display device (200) during the magnetism status determination reference period,
in a case in which a determination is made that there is an abnormality in the operation of the hand after displaying said information on the display (131) and even after the magnetism status determination reference period passes,
if the determination that an occurrence of an abnormality is detected after the magnetism status determination reference period passes
is identical to the stored determination, displaying said information on the display (131), and
if different from the stored determination, displaying a subsequent information on the display (131).

13. A computer program comprising instructions which, when executed by a computer of an electronic apparatus (100) of claim 1, cause the computer to perform the method of claim 12.

## Patentansprüche

1. Elektronische Einrichtung (100), die mindestens einen Prozessor (110) und eine Anzeige (131) umfasst, wobei
der Prozessor (110) konfiguriert ist zum
Erfassen, von einer Zeitanzeigevorrichtung (200), von Protokolldaten der Zeitanzeigevorrichtung (200), und
Bestimmen, auf der Grundlage der erfassten Protokolldaten und mit einem von der elektronischen Einrichtung (100) empfangenen Eingabebefehl von einem Benutzer als einen Auslöser, eines Status, ob die Zeitanzeigevorrichtung (200) abnormal ist,
**dadurch gekennzeichnet, dass**
der Prozessor (110) weiter konfiguriert ist zum
Anzeigen, auf der Anzeige (131), von Informationen, die dem folgenden bestimmten Status der Zeitanzeigevorrichtung (200) entsprechen,
Bestimmen, ob während eines Magnetismusstatusbestimmungsreferenzzeitraums eine Abnormalität in einem Betrieb eines Zeigers der Zeitanzeigevorrichtung (200) vorliegt, und
Anzeigen einer Information auf der Anzeige (131), wenn bestimmt wird, dass eine Abnormalität in dem Betrieb des Zeigers vorliegt, und
bei der Bestimmung, ob eine Abnormalität in dem Betrieb des Zeigers vorliegt, wird bestimmt, dass eine Abnormalität in dem Betrieb des Zeigers vorliegt, wenn ein Auftreten einer Abnormalität bei einem oder mehreren detektiert wird von
einer ersten Bestimmung, bei der es sich um eine Bestimmung handelt, ob eine Abnormalität periodisch auftritt, wobei die Abnormalität darin besteht, dass ein automatischer Korrekturbetrag einer Zeigerposition, durchgeführt von der Zeitanzeigevorrichtung (200), größer oder gleich einem Referenzkorrekturbetrag ist,
einer zweiten Bestimmung, bei der es sich um eine Bestimmung handelt, ob eine Abnormalität periodisch auftritt, wobei die Abnormalität darin besteht, dass sich die Polarität eines Motors in der Zeitanzeigevorrichtung (200) umkehrt,
einer dritten Bestimmung, bei der es sich um eine Bestimmung handelt, ob eine Abnormalität periodisch auftritt, wobei die Abnormalität darin besteht, dass eine Positionsdetektion eines Zahnrads in der Zeitanzeigevorrichtung (200) innerhalb eines zweiten Magnetstatusbestimmungsreferenzzeitraums nach einer ersten Kopplung mit der Zeitanzeigevorrichtung (200) nicht möglich ist, und
einer vierten Bestimmung, bei der es sich um eine Bestimmung handelt, ob eine Abnormalität periodisch auftritt, wobei die Abnormalität darin besteht, dass der Motor mit einem maximalen ParCon-Pegel betrieben wird, der die Stärke eines Stroms ausdrückt, der an den Impulsmotor angelegt wird, der die Zeiger bewegt, in der Zeitanzeigevorrichtung (200), außerdem der automatische Korrekturbetrag der Zeigerposition 0 ist und außerdem ein Korrekturimpuls mit einem Prozentsatz erzeugt wird, der größer oder gleich einem Referenzprozentsatz innerhalb des zweiten Magnetstatusbestimmungsreferenzzeitraums nach der ersten Kopplung mit der Zeitanzeigevorrichtung (200) ist,
beim Anzeigen der Informationen auf der Anzeige (131) wird eine Bestimmung gespeichert, dass ein Auftreten einer Abnormalität bei der ersten Bestimmung bis zu der vierten Bestimmung detektiert wurde,
nach dem Anzeigen der Informationen auf der Anzeige (131) wird weiter bestimmt, ob während des Magnetismusstatusbestimmungsreferenzzeitraums eine Abnormalität in dem Betrieb des Zeigers der Zeitanzeigevorrichtung (200) vorliegt,
in einem Fall, bei dem bestimmt wird, dass eine Abnormalität in dem Betrieb des Zeigers vorliegt, nachdem die Informationen auf der Anzeige (131) angezeigt wurden und selbst nachdem der Magnetismusstatusbestimmungsreferenzzeitraum abgelaufen ist,
wenn die Bestimmung, dass ein Auftreten einer Abnormalität nach Ablauf des Magnetismusstatusbestimmungsreferenzzeitraums detektiert wurde
mit der gespeicherten Bestimmung identisch ist, werden die Informationen auf der Anzeige (131) angezeigt, und
wenn sie von der gespeicherten Bestimmung abweicht, werden nachfolgende Informationen auf der Anzeige (131) angezeigt.

2. Elektronische Einrichtung (100) nach Anspruch 1, weiter umfassend:
einen Speicher (120), wobei
der Prozessor (110) konfiguriert ist zum
Erfassen der Protokolldaten der Zeitanzeigevorrichtung (200) von der Zeitanzeigevorrichtung (200) und Sammeln der erfassten Protokolldaten in dem Speicher (120), und
Bestimmen, auf der Grundlage der in dem Speicher (120) gesammelten Protokolldaten und mit dem von der elektronischen Einrichtung (100) empfangenen Eingabebefehl als den Auslöser, des Status, ob die Zeitanzeigevorrichtung (200) abnormal ist.

3. Elektronische Einrichtung (100) nach Anspruch 1 oder 2, weiter umfassend:
eine Eingabeempfangsvorrichtung (132), die den Eingabebefehl von dem Benutzer empfängt, wobei
der Prozessor (110) so konfiguriert ist, dass er auf der Grundlage der erfassten Protokolldaten und mit dem von der Eingabeempfangsvorrichtung (132) empfangenen Eingabebefehl von dem Benutzer als den Auslöser den Status bestimmt, ob die Zeitanzeigevorrichtung (200) abnormal ist.

4. Elektronische Einrichtung (100) nach einem der Ansprüche 1 bis 3, wobei
der Prozessor (110) konfiguriert ist zum
Erfassen, auf der Grundlage des Eingabebefehls, der Protokolldaten, und
Bestimmen, auf der Grundlage der erfassten Protokolldaten, des Status der Zeitanzeigevorrichtung (200).

5. Elektronische Einrichtung (100) nach Anspruch 4, wobei
der Prozessor (110) konfiguriert ist zum
Bestimmen, dass die Zeitanzeigevorrichtung (200) normal ist, in einem Fall, bei dem, wenn die elektronische Einrichtung (100) den Eingabebefehl empfängt, eine gesammelte Menge der Protokolldaten einer Referenzsammelmenge nicht entspricht.

6. Elektronische Einrichtung (100) nach einem der Ansprüche 1 bis 5, wobei
der Prozessor (110) konfiguriert ist zum
Nicht-Akzeptieren des Eingabebefehls für einen nachfolgenden vorbestimmten Eingabeignorierzeitraum, wenn bestimmt wird, dass die Zeitanzeigevorrichtung (200) abnormal ist.

7. Elektronische Einrichtung (100) nach einem der Ansprüche 1 bis 6, wobei
der Prozessor (110) konfiguriert ist zum
automatischen Bestimmen, zu einem vorbestimmten Zeitpunkt, des Status, ob die Zeitanzeigevorrichtung (200) abnormal ist, auch ohne den Eingabebefehl.

8. Elektronische Einrichtung (100) nach Anspruch 7, wobei
der Prozessor (110) konfiguriert ist zum
nicht automatischen Durchführen einer Bestimmung des Status der Zeitanzeigevorrichtung (200) für einen vorbestimmten Autoignorierzeitraum, wenn der Status der Zeitanzeigevorrichtung (200) auf der Grundlage des Eingabebefehls bestimmt wurde.

9. Elektronische Einrichtung (100) nach einem der Ansprüche 1 bis 8, wobei die Zeitanzeigevorrichtung (200) eine analoge Uhr ist.

10. Elektronische Einrichtung (100) nach einem der Ansprüche 1 bis 9, wobei die elektronische Einrichtung (100) die Protokolldaten von der Zeitanzeigevorrichtung (200) durch drahtlose Kommunikation erfasst.

11. Bestimmungssystem (1000), das eine Zeitanzeigevorrichtung (200) und eine elektronische Einrichtung (100) umfasst, wobei
die elektronische Einrichtung (100) mindestens einen Prozessor (110) und eine Anzeige (131) enthält und
der Prozessor (110) konfiguriert ist zum
Erfassen, von der Zeitanzeigevorrichtung (200), von Protokolldaten der Zeitanzeigevorrichtung (200) und
Bestimmen, auf der Grundlage der erfassten Protokolldaten und mit einem von der elektronischen Einrichtung (100) empfangenen Eingabebefehl von einem Benutzer als einen Auslöser, eines Status, ob die Zeitanzeigevorrichtung (200) abnormal ist,
**dadurch gekennzeichnet, dass**
der Prozessor (110) weiter konfiguriert ist zum
Anzeigen, auf der Anzeige (131), von Informationen, die dem folgenden bestimmten Status der Zeitanzeigevorrichtung (200) entsprechen,
Bestimmen, ob während eines Magnetismusstatusbestimmungsreferenzzeitraums eine Abnormalität in einem Betrieb eines Zeigers der Zeitanzeigevorrichtung (200) vorliegt, und
Anzeigen einer Information auf der Anzeige (131), wenn bestimmt wird, dass eine Abnormalität in dem Betrieb des Zeigers vorliegt, und
bei der Bestimmung, ob eine Abnormalität in dem Betrieb des Zeigers vorliegt, bestimmt wird, dass eine Abnormalität in dem Betrieb des Zeigers vorliegt, wenn ein Auftreten einer Abnormalität in einem oder mehreren detektiert wird von
einer ersten Bestimmung, bei der es sich um eine Bestimmung handelt, ob eine Abnormalität periodisch auftritt, wobei die Abnormalität darin besteht, dass ein automatischer Korrekturbetrag einer Zeigerposition, durchgeführt von der Zeitanzeigevorrichtung (200), größer oder gleich einem Referenzkorrekturbetrag ist,
einer zweiten Bestimmung, bei der es sich um eine Bestimmung handelt, ob eine Abnormalität periodisch auftritt, wobei die Abnormalität darin besteht, dass sich eine Polarität eines Motors in der Zeitanzeigevorrichtung (200) umkehrt,
einer dritten Bestimmung, bei der es sich um eine Bestimmung handelt, ob eine Abnormalität periodisch auftritt, wobei die Abnormalität darin besteht, dass eine Positionsdetektion eines Zahnrads in der Zeitanzeigevorrichtung (200) innerhalb eines zweiten Magnetstatusbestimmungsreferenzzeitraums nach einer ersten Kopplung mit der Zeitanzeigevorrichtung (200) nicht möglich ist, und
einer vierten Bestimmung, bei der es sich um eine Bestimmung handelt, ob eine Abnormalität periodisch auftritt, wobei die Abnormalität darin besteht, dass der Motor mit einem maximalen ParCon-Pegel betrieben wird, der die Stärke eines Stroms ausdrückt, der an den Impulsmotor angelegt wird, der die Zeiger bewegt, in der Zeitanzeigevorrichtung (200), außerdem der automatische Korrekturbetrag der Zeigerposition 0 ist und außerdem ein Korrekturimpuls mit einem Prozentsatz erzeugt wird, der größer oder gleich einem Referenzprozentsatz innerhalb des zweiten Magnetstatusbestimmungsreferenzzeitraums nach der ersten Kopplung mit der Zeitanzeigevorrichtung (200) ist,
beim Anzeigen der Informationen auf der Anzeige (131) wird eine Bestimmung gespeichert, dass ein Auftreten einer Abnormalität bei der ersten Bestimmung bis zu der vierten Bestimmung detektiert wurde,
nach dem Anzeigen der Informationen auf der Anzeige (131) wird weiter bestimmt, ob während des Magnetismusstatusbestimmungsreferenzzeitraums eine Abnormalität in dem Betrieb des Zeigers der Zeitanzeigevorrichtung (200) vorliegt,
in einem Fall, bei dem bestimmt wird, dass eine Abnormalität in dem Betrieb des Zeigers vorliegt, nachdem die Informationen auf der Anzeige (131) angezeigt wurden und selbst nachdem der Magnetismusstatusbestimmungsreferenzzeitraum abgelaufen ist,
wenn die Bestimmung, dass ein Auftreten einer Abnormalität nach Ablauf des Magnetismusstatusbestimmungsreferenzzeitraums detektiert wurde,
mit der gespeicherten Bestimmung identisch ist, werden die Informationen auf der Anzeige (131) angezeigt, und
wenn sie von der gespeicherten Bestimmung abweicht, werden nachfolgende Informationen auf der Anzeige (131) angezeigt.

12. Bestimmungsverfahren einer elektronischen Einrichtung (100), die eine Anzeige (131) umfasst, wobei das Verfahren umfasst:
Erfassen, von einer Zeitanzeigevorrichtung (200), von Protokolldaten der Zeitanzeigevorrichtung (200); und
Bestimmen, auf der Grundlage der erfassten Protokolldaten und mit einem von der elektronischen Einrichtung (100) empfangenen Eingabebefehl von einem Benutzer als einen Auslöser, eines Status, ob die Zeitanzeigevorrichtung (200) abnormal ist,
**dadurch gekennzeichnet, dass**
das Bestimmungsverfahren weiter umfasst:
Anzeigen von Informationen auf der Anzeige (131), die dem folgenden bestimmten Status der Zeitanzeigevorrichtung (200) entsprechen,
Bestimmen, ob während eines Magnetismusstatusbestimmungsreferenzzeitraums eine Abnormalität in dem Betrieb eines Zeigers der Zeitanzeigevorrichtung (200) vorliegt, und
Anzeigen einer Information auf der Anzeige (131), wenn bestimmt wird, dass eine Abnormalität in dem Betrieb des Zeigers vorliegt, und
bei der Bestimmung, ob eine Abnormalität in dem Betrieb des Zeigers vorliegt, wird bestimmt, dass eine Abnormalität in dem Betrieb des Zeigers vorliegt, wenn ein Auftreten einer Abnormalität in einem oder mehreren detektiert wird von
einer ersten Bestimmung, bei der es sich um eine Bestimmung handelt, ob eine Abnormalität periodisch auftritt, wobei die Abnormalität darin besteht, dass ein automatischer Korrekturbetrag einer Zeigerposition, durchgeführt von der Zeitanzeigevorrichtung (200), größer oder gleich einem Referenzkorrekturbetrag ist,
einer zweiten Bestimmung, bei der es sich um eine Bestimmung handelt, ob eine Abnormalität periodisch auftritt, wobei die Abnormalität darin besteht, dass sich die Polarität eines Motors in der Zeitanzeigevorrichtung (200) umkehrt,
einer dritten Bestimmung, bei der es sich um eine Bestimmung handelt, ob eine Abnormalität periodisch auftritt, wobei die Abnormalität darin besteht, dass eine Positionsdetektion eines Zahnrads in der Zeitanzeigevorrichtung (200) innerhalb eines zweiten Magnetstatusbestimmungsreferenzzeitraums nach einer ersten Kopplung mit der Zeitanzeigevorrichtung (200) nicht möglich ist, und
einer vierten Bestimmung, bei der es sich um eine Bestimmung handelt, ob eine Abnormalität periodisch auftritt, wobei die Abnormalität darin besteht, dass der Motor mit einem maximalen ParCon-Pegel betrieben wird, der die Stärke eines Stroms ausdrückt, der an den Impulsmotor angelegt wird, der die Zeiger bewegt, in der Zeitanzeigevorrichtung (200), außerdem der automatische Korrekturbetrag der Zeigerposition 0 ist und außerdem ein Korrekturimpuls mit einem Prozentsatz erzeugt wird, der größer oder gleich einem Referenzprozentsatz innerhalb des zweiten Magnetstatusbestimmungsreferenzzeitraums nach der ersten Kopplung mit der Zeitanzeigevorrichtung (200) ist,
beim Anzeigen der Informationen auf der Anzeige (131) wird eine Bestimmung gespeichert, dass ein Auftreten einer Abnormalität bei der ersten Bestimmung bis zu der vierten Bestimmung detektiert wurde,
nach dem Anzeigen der Informationen auf der Anzeige (131) wird weiter bestimmt, ob während des Magnetismusstatusbestimmungsreferenzzeitraums eine Abnormalität in dem Betrieb des Zeigers der Zeitanzeigevorrichtung (200) vorliegt,
in einem Fall, bei dem bestimmt wird, dass eine Abnormalität in dem Betrieb des Zeigers vorliegt, nachdem die Informationen auf der Anzeige (131) angezeigt wurden und selbst nachdem der Magnetismusstatusbestimmungsreferenzzeitraum abgelaufen ist,
wenn die Bestimmung, dass ein Auftreten einer Abnormalität nach Ablauf des Magnetismusstatusbestimmungsreferenzzeitraums detektiert wurde,
mit der gespeicherten Bestimmung identisch ist, werden die Informationen auf der Anzeige (131) angezeigt, und
wenn sie von der gespeicherten Bestimmung abweicht, werden nachfolgende Informationen auf der Anzeige (131) angezeigt.

13. Computerprogramm, das Anweisungen umfasst, die, wenn sie von einem Computer einer elektronischen Einrichtung (100) nach Anspruch 1 ausgeführt werden, den Computer veranlassen, das Verfahren nach Anspruch 12 auszuführen.

## Revendications

1. Appareil électronique (100) comprenant au moins un processeur (110) et un afficheur (131), dans lequel
le processeur (110) est configuré pour
acquérir, à partir d'un dispositif d'affichage de l'heure (200), des données de journal du dispositif d'affichage de l'heure (200), et
déterminer, sur la base des données de journal acquises et avec une commande d'entrée reçue d'un utilisateur par l'appareil électronique (100) en tant que déclencheur, un état indiquant si le dispositif d'affichage de l'heure (200) est anormal,
**caractérisé en ce que**
le processeur (110) est en outre configuré pour
afficher, sur l'afficheur (131), des informations correspondant à l'état déterminé suivant du dispositif d'affichage de l'heure (200),
déterminer s'il existe une anomalie dans un fonctionnement d'une aiguille du dispositif d'affichage de l'heure (200) au cours d'une période de référence de détermination d'état de magnétisme, et
afficher des informations sur l'afficheur (131) s'il est déterminé qu'il existe une anomalie dans le fonctionnement de l'aiguille, et
pour déterminer s'il existe une anomalie dans le fonctionnement de l'aiguille, il est déterminé qu'il existe une anomalie dans le fonctionnement de l'aiguille si une occurrence d'une anomalie est détectée dans une ou plusieurs parmi
une première détermination qui consiste à déterminer si une anomalie a lieu périodiquement, l'anomalie étant qu'une quantité de correction automatique d'une position d'aiguille effectuée par le dispositif d'affichage de l'heure (200) est supérieure ou égale à une quantité de correction de référence,
une deuxième détermination qui consiste à déterminer si une anomalie a lieu périodiquement, l'anomalie étant qu'une polarité d'un moteur est inversée dans le dispositif d'affichage de l'heure (200),
une troisième détermination qui consiste à déterminer si une anomalie a lieu périodiquement, l'anomalie étant qu'une détection de position d'un rouage dans le dispositif d'affichage de l'heure (200) n'est pas possible en l'espace d'une deuxième période de référence de détermination d'état magnétique à partir d'un premier couplage avec le dispositif d'affichage de l'heure (200), et
une quatrième détermination qui consiste à déterminer si une anomalie a lieu périodiquement, l'anomalie étant que le moteur est entraîné à un niveau ParCon maximum, exprimant l'intensité d'un courant appliqué au moteur à impulsions qui déplace les aiguilles, dans le dispositif d'affichage de l'heure (200), également, que la quantité de correction automatique de la position d'aiguille est égale à 0 et, également, qu'une impulsion de correction est générée à un pourcentage supérieur ou égal à un pourcentage de référence en l'espace de la deuxième période de référence de détermination d'état magnétique à partir du premier couplage avec le dispositif d'affichage de l'heure (200),
lors de l'affichage desdites informations sur l'afficheur (131), enregistrer une détermination qu'une occurrence d'une anomalie est détectée parmi les déterminations allant de la première détermination à la quatrième détermination,
après affichage desdites informations sur l'afficheur (131), déterminer en outre s'il existe une anomalie dans le fonctionnement de l'aiguille du dispositif d'affichage de l'heure (200) au cours de la période de référence de détermination d'état de magnétisme,
dans un cas où il est déterminé qu'il existe une anomalie dans le fonctionnement de l'aiguille après affichage desdites informations sur l'afficheur (131) et même après que s'est écoulée la période de référence de détermination d'état de magnétisme,
si la détermination qu'une occurrence d'une anomalie est détectée après que s'est écoulée la période de référence de détermination d'état de magnétisme
est identique à la détermination enregistrée, lesdites informations sont affichées sur l'afficheur (131), et
si elle est différente de la détermination enregistrée, des informations subséquentes sont affichées sur l'afficheur (131).

2. Appareil électronique (100) selon la revendication 1, comprenant en outre :
une mémoire (120), dans lequel
le processeur (110) est configuré pour
acquérir les données de journal du dispositif d'affichage de l'heure (200) à partir du dispositif d'affichage de l'heure (200) et accumuler dans la mémoire (120) les données de journal acquises, et
déterminer, sur la base des données de journal accumulées dans la mémoire (120) et avec la commande d'entrée reçue par l'appareil électronique (100) en tant que le déclencheur, l'état indiquant si le dispositif d'affichage de l'heure (200) est anormal.

3. Appareil électronique (100) selon la revendication 1 ou 2, comprenant en outre :
un dispositif récepteur d'entrée (132) qui reçoit de l'utilisateur la commande d'entrée, dans lequel
le processeur (110) est configuré pour déterminer, sur la base des données de journal acquises et avec la commande d'entrée reçue de l'utilisateur par le dispositif récepteur d'entrée (132) en tant que le déclencheur, l'état indiquant si le dispositif d'affichage de l'heure (200) est anormal.

4. Appareil électronique (100) selon l'une quelconque des revendications 1 à 3, dans lequel
le processeur (110) est configuré pour
acquérir, sur la base de la commande d'entrée, les données de journal, et
déterminer, sur la base des données de journal acquises, l'état du dispositif d'affichage de l'heure (200).

5. Appareil électronique (100) selon la revendication 4, dans lequel
le processeur (110) est configuré pour
déterminer que le dispositif d'affichage de l'heure (200) est normal dans un cas où, lorsque l'appareil électronique (100) reçoit la commande d'entrée, une quantité accumulée des données de journal ne satisfait pas à une quantité d'accumulation de référence.

6. Appareil électronique (100) selon l'une quelconque des revendications 1 à 5, dans lequel
le processeur (110) est configuré pour
s'il est déterminé que le dispositif d'affichage de l'heure (200) est anormal, ne pas accepter la commande d'entrée pendant une période d'ignorance d'entrée préétablie subséquente.

7. Appareil électronique (100) selon l'une quelconque des revendications 1 à 6, dans lequel
le processeur (110) est configuré pour
déterminer automatiquement, à un instant préétabli, l'état indiquant si le dispositif d'affichage de l'heure (200) est anormal, même sans la commande d'entrée.

8. Appareil électronique (100) selon la revendication 7, dans lequel
le processeur (110) est configuré pour
si l'état du dispositif d'affichage de l'heure (200) est déterminé sur la base de la commande d'entrée, ne pas effectuer automatiquement une détermination de l'état du dispositif d'affichage de l'heure (200) pendant une période d'ignorance automatique préétablie.

9. Appareil électronique (100) selon l'une quelconque des revendications 1 à 8, dans lequel le dispositif d'affichage de l'heure (200) est un garde-temps analogique.

10. Appareil électronique (100) selon l'une quelconque des revendications 1 à 9, dans lequel l'appareil électronique (100) acquiert les données de journal depuis le dispositif d'affichage de l'heure (200) par communication sans fil.

11. Système de détermination (1000), comprenant un dispositif d'affichage de l'heure (200) et un appareil électronique (100), dans lequel
l'appareil électronique (100) comprend au moins un processeur (110) et un afficheur (131), et
le processeur (110) est configuré pour
acquérir, à partir du dispositif d'affichage de l'heure (200), des données de journal du dispositif d'affichage de l'heure (200), et
déterminer, sur la base des données de journal acquises et avec une commande d'entrée reçue d'un utilisateur par l'appareil électronique (100) en tant que déclencheur, un état indiquant si le dispositif d'affichage de l'heure (200) est anormal
**caractérisé en ce que**
le processeur (110) est en outre configuré pour
afficher, sur l'afficheur (131), des informations correspondant à l'état déterminé suivant du dispositif d'affichage de l'heure (200),
déterminer s'il existe une anomalie dans un fonctionnement d'une aiguille du dispositif d'affichage de l'heure (200) au cours d'une période de référence de détermination de l'état de magnétisme, et
afficher des informations sur l'afficheur (131) s'il est déterminé qu'il existe une anomalie dans le fonctionnement de l'aiguille, et
pour déterminer s'il existe une anomalie dans le fonctionnement de l'aiguille, il est déterminé qu'il existe une anomalie dans le fonctionnement de l'aiguille si une occurrence d'une anomalie est détectée dans une ou plusieurs parmi
une première détermination qui consiste à déterminer si une anomalie a lieu périodiquement, l'anomalie étant qu'une quantité de correction automatique d'une position d'aiguille effectuée par le dispositif d'affichage de l'heure (200) est supérieure ou égale à une quantité de correction de référence,
une deuxième détermination qui consiste à déterminer si une anomalie a lieu périodiquement, l'anomalie étant qu'une polarité d'un moteur est inversée dans le dispositif d'affichage de l'heure (200),
une troisième détermination qui consiste à déterminer si une anomalie a lieu périodiquement, l'anomalie étant qu'une détection de position d'un rouage dans le dispositif d'affichage de l'heure (200) n'est pas possible en l'espace d'une deuxième période de référence de détermination d'état magnétique à partir d'un premier couplage avec le dispositif d'affichage de l'heure (200), et
une quatrième détermination qui consiste à déterminer si une anomalie a lieu périodiquement, l'anomalie étant que le moteur est entraîné à un niveau ParCon maximum, exprimant l'intensité d'un courant appliqué au moteur à impulsions qui déplace les aiguilles, dans le dispositif d'affichage de l'heure (200), également, que la quantité de correction automatique de la position d'aiguille est égale à 0 et, également, qu'une impulsion de correction est générée à un pourcentage supérieur ou égal à un pourcentage de référence en l'espace de la deuxième période de référence de détermination d'état magnétique à partir du premier couplage avec le dispositif d'affichage de l'heure (200),
lors de l'affichage desdites informations sur l'afficheur (131), enregistrer une détermination qu'une occurrence d'une anomalie est détectée parmi les déterminations allant de la première détermination à la quatrième détermination,
après affichage desdites informations sur l'afficheur (131), déterminer en outre s'il existe une anomalie dans le fonctionnement de l'aiguille du dispositif d'affichage de l'heure (200) au cours de la période de référence de détermination d'état de magnétisme,
dans un cas où il est déterminé qu'il existe une anomalie dans le fonctionnement de l'aiguille après affichage desdites informations sur l'afficheur (131) et même après que s'est écoulée la période de référence de détermination d'état de magnétisme,
si la détermination qu'une occurrence d'une anomalie est détectée après que s'est écoulée la période de référence de détermination d'état de magnétisme
est identique à la détermination enregistrée, lesdites informations sont affichées sur l'afficheur (131), et
si elle est différente de la détermination enregistrée, des informations subséquentes sont affichées sur l'afficheur (131).

12. Procédé de détermination d'un appareil électronique (100) comprenant un afficheur (131), le procédé de détermination comprenant les étapes consistant à :
acquérir, à partir du dispositif d'affichage de l'heure (200), des données de journal du dispositif d'affichage de l'heure (200), et
déterminer, sur la base des données de journal acquises et avec une commande d'entrée reçue d'un utilisateur par l'appareil électronique (100) en tant que déclencheur, un état indiquant si le dispositif d'affichage de l'heure (200) est anormal,
**caractérisé en ce que**
le procédé de détermination comprend en outre :
afficher, sur l'afficheur (131), des informations correspondant à l'état déterminé suivant du dispositif d'affichage de l'heure (200),
déterminer s'il existe une anomalie dans un fonctionnement d'une aiguille du dispositif d'affichage de l'heure (200) au cours d'une période de référence de détermination de l'état de magnétisme, et
afficher des informations sur l'afficheur (131) s'il est déterminé qu'il existe une anomalie dans le fonctionnement de l'aiguille, et
pour déterminer s'il existe une anomalie dans le fonctionnement de l'aiguille, il est déterminé qu'il existe une anomalie dans le fonctionnement de l'aiguille si une occurrence d'une anomalie est détectée dans une ou plusieurs parmi
une première détermination qui consiste à déterminer si une anomalie a lieu périodiquement, l'anomalie étant qu'une quantité de correction automatique d'une position d'aiguille effectuée par le dispositif d'affichage de l'heure (200) est supérieure ou égale à une quantité de correction de référence,
une deuxième détermination qui consiste à déterminer si une anomalie a lieu périodiquement, l'anomalie étant qu'une polarité d'un moteur est inversée dans le dispositif d'affichage de l'heure (200),
une troisième détermination qui consiste à déterminer si une anomalie a lieu périodiquement, l'anomalie étant qu'une détection de position d'un rouage dans le dispositif d'affichage de l'heure (200) n'est pas possible en l'espace d'une deuxième période de référence de détermination d'état magnétique à partir d'un premier couplage avec le dispositif d'affichage de l'heure (200), et
une quatrième détermination qui consiste à déterminer si une anomalie a lieu périodiquement, l'anomalie étant que le moteur est entraîné à un niveau ParCon maximum, exprimant l'intensité d'un courant appliqué au moteur à impulsions qui déplace les aiguilles, dans le dispositif d'affichage de l'heure (200), également, que la quantité de correction automatique de la position d'aiguille est égale à 0 et, également, qu'une impulsion de correction est générée à un pourcentage supérieur ou égal à un pourcentage de référence en l'espace de la deuxième période de référence de détermination d'état magnétique à partir du premier couplage avec le dispositif d'affichage de l'heure (200),
lors de l'affichage desdites informations sur l'afficheur (131), enregistrer une détermination qu'une occurrence d'une anomalie est détectée parmi les déterminations allant de la première détermination à la quatrième détermination,
après affichage desdites informations sur l'afficheur (131), déterminer en outre s'il existe une anomalie dans le fonctionnement de l'aiguille du dispositif d'affichage de l'heure (200) au cours de la période de référence de détermination d'état de magnétisme,
dans un cas où il est déterminé qu'il existe une anomalie dans le fonctionnement de l'aiguille après affichage desdites informations sur l'afficheur (131) et même après que s'est écoulée la période de référence de détermination d'état de magnétisme,
si la détermination qu'une occurrence d'une anomalie est détectée après que s'est écoulée la période de référence de détermination d'état de magnétisme
est identique à la détermination enregistrée, afficher lesdites informations sur l'afficheur (131), et
si elle est différente de la détermination enregistrée, afficher des informations subséquentes sur l'afficheur (131).

13. Programme informatique comprenant des instructions qui, lorsqu'elles sont exécutées par un ordinateur d'un appareil électronique (100) selon la revendication 1, amènent l'ordinateur à exécuter le procédé selon la revendication 12.
